(19) Europäisches Patentamt

European Patent Office

Office européen des brevets

(11) **EP 1 147 613 B1**

(12) **EUROPÄISCHE PATENTSCHRIFT**

(45) Veröffentlichungstag und Bekanntmachung des Hinweises auf die Patenterteilung:
**30.11.2005 Patentblatt 2005/48**

(21) Anmeldenummer: **99968395.6**

(22) Anmeldetag: **29.12.1999**

(51) Int Cl.7: **H03M 13/00**

(86) Internationale Anmeldenummer:
**PCT/EP1999/010459**

(87) Internationale Veröffentlichungsnummer:
**WO 2000/041315 (13.07.2000 Gazette 2000/28)**

(54) **VERFAHREN ZUR ÜBERTRAGUNG QUELLENCODIERTER DIGITALER SIGNALE**

METHOD FOR TRANSMITTING SOURCE ENCODED DIGITAL SIGNALS

PROCEDE DE TRANSMISSION DE SIGNAUX NUMERIQUES CODES A LA SOURCE

(84) Benannte Vertragsstaaten:
**AT BE CH CY DE DK ES FI FR GB GR IE IT LI LU MC NL PT SE**

(30) Priorität: **30.12.1998 DE 19860531**

(43) Veröffentlichungstag der Anmeldung:
**24.10.2001 Patentblatt 2001/43**

(73) Patentinhaber: **TELEFONAKTIEBOLAGET LM ERICSSON (publ)**
**164 83 Stockholm (SE)**

(72) Erfinder:
- **HAGENAUER, Joachim**
  **D-82229 Seefeld (DE)**
- **STOCKHAMMER, Thomas**
  **D-83346 Bergen (DE)**
- **WEISS, Christian**
  **D-86381 Krumbach (DE)**
- **DENK, Wolfgang**
  **D-87490 Haldenwang (DE)**

(74) Vertreter: **Tonscheidt, Andreas**
**Ericsson GmbH**
**Ericsson Allee 1**
**52134 Herzogenrath (DE)**

(56) Entgegenhaltungen:
- A. HEEGER: "Information theoretical based esign of hierarchical channel coding and modulation for mobile radio channels" SIGNAL PROCESSING: IMAGE COMMUNICATION, Bd. 12, April 1998 (1998-04), Seiten 117-125, XP004121503
- C. BERROU UND P. COMBELLES: "Digital Television: Hierarchical Channel Coding using Turbo-Codes" INTERNATIONAL CONFERENCE ON COMMUNICATIONS (ICC),US,NEW YORK, IEEE, 1. Mai 1994 (1994-05-01), Seiten 1255-1259, XP000438701
- J. HAGENAUER: "Rate-Compatible Punctured Convolutional Codes (RCPC Codes) and their Applications." IEEE TRANSACTIONS ON COMMUNICATIONS, Bd. 36, Nr. 4, April 1988 (1988-04), Seiten 389-400, XP002137975
- P. HOEHER, J. HAGENAUER, E. OFFER, CH. RAPP UND H. SCHULTZE: "Peformance of an RCPC-Coded OFDM-based Digital Audio Broadcasting (DAB) System" IEEE GLOBAL TELECOMMUNICATIONS CONFERENCE GLOBECOM '91, 2. Dezember 1991 (1991-12-02), Seiten 40-46, XP000325944 Phoenix, AZ
- UNEQUAL ERROR PROTECTION FOR DIGITAL MOBILE DS-CDMA RADIO SYSTEMS : " UNEQUAL ERROR PROTECTION FOR DIGITAL MOBILE DS-CDMA RADIO SYSTEMS " UNEQUAL ERROR PROTECTION FOR DIGITAL MOBILE DS-CDMA RADIO SYSTEMS , XP000438698
- C. SCHLEGEL: "Trellis Coding" Juni 1997 (1997-06) , IEEE PRESS XP002137976 Seite 153 -Seite 191 Seite 157, Zeile 5 -Seite 160, Zeile 11

**Beschreibung**

Technisches Gebiet

Die Erfindung betrifft ein Verfahren zur Übertragung quellencodierter digitaler Signale, denen bitweise, symbolweise oder in Gruppen unterschiedliche Wichtigkeiten zuordenbar sind, in Datenrahmen über einen Kanal.

Stand der Technik

Die Einsatzgebiete des Verfahrens, auf das sich die Erfindung bezieht, sind im allgemeinen die Übertragung oder Speicherung von digital codierten Signalen auf fehlerbehafteten Kanälen. Beispiele für Signale sind u.a. Sprache, Text, Ton, Bilder, Video oder Meßsignale. Unter Kanal wird im folgenden jede denkbare Art des Übertragungsmediums, Speichermediums oder dergleichen verstanden.

Beispiele für Übertragungsmedien sind zum einen die Luftschnittstelle bei einer nicht leitungsgebundenen Übertragung, beispielsweise bei Mobil- oder Rundfunk (Broadcast), aber auch bei "Radio in the Local Loop"-Systemen (drahtlose Teilnehmeranschlußleitung zur Überbrückung der letzten Meile), zum anderen jede Art eines leitungsgebundenen Systems, das keine fehlerfreie Übertragung garantieren kann. Stellvertretend seien hier protokollbedingte Paketverluste bei IP (Internet Protokoll) oder ATM (Asynchroner Transfer-Modus) genannt, die auch im Falle einer leitungsgebundenen Glasfaserübertragung zu Paketverlusten führen. Solche Paketverluste entstehen beispielsweise durch Pufferüberlauf oder Verletzung einer maximalen Verzögerungsanforderung. Stellvertretend für Speichermedien seien an dieser Stelle nur die optische, magnetische oder magnetooptische Aufzeichnung digitaler Daten genannt.

In der Übertragungstechnik gibt es im allgemeinen eine relevante Schnittstelle, nämlich die Schnittstelle zwischen der Quellen- und der Kanalcodierung. Für die Wahl dieser Schnittstelle zwischen Quellen- und Kanalcodierung gibt es mehrere Gründe. Zum einen ist durch die Informationstheorie gezeigt, daß unter bestimmten Voraussetzungen diese Schnittstelle einfach und wichtig ist. Binäre Daten werden im Idealfall mit Hilfe von Verfahren der Quellencodierung in einer optimalen Weise erzeugt und können dann durch die Kanalcodierung und die nachfolgenden Verarbeitungsschritte in optimaler Weise übertragen werden. Zum anderen wird durch diese einfache Schnittstelle der an sich eigenständige Bereich der Anwendungen mit dem an sich eigenständigen Bereich der Übertragungssysteme verbunden.

Sowohl in Standardisierungen als auch in der Implementierung eignet sich diese Schnittstelle ideal zur Abgrenzung verschiedener Aufgaben. Diese Schnittstelle definiert im allgemeinen aber keinerlei Übertragungsformat. Deshalb kann zusätzlich noch eine Unterscheidung zwischen paket- und verbindungsorientierter Übertragung gemacht werden, wobei bei paketorientierter Übertragung die Integrität der Paketgrenzen garantiert werden muß, während bei verbindungsorientierter Übertragung von einem kontinuierlichen Bitstrom ausgegangen wird.

Diese flexible und gleichzeitig universelle Eigenschaft digitaler Übertragungssysteme ist ein Hauptgrund für deren Erfolg. Das Aufnehmen neuer Anwendungen und Dienste, deren zugrunde liegende Daten binär codiert sind, in ein solches System ist einfach und kostengünstig. Anwendungen bezeichnen im folgenden durch Quellencodierverfahren in ein übertragungsgerechtes bzw. speichergerechtes Datenformat umgewandelte Signale. Anwendungen bzw. Dienste werden einer Übertragung einfach dadurch zugänglich gemacht, daß die ihnen zugrunde liegenden Daten das geforderte Übertragungsformat aufweisen, d.h. die Daten müssen beispielsweise binär codiert sein.

Allerdings ergeben sich bei einer Kombination beliebiger Übertragungsmedien und Anwendungen Einschränkungen bei dieser einfachen Schnittstelle. Viele Kanäle haben aufgrund physikalischer Gegebenheiten zeitlich und/oder räumlich variierende Übertragungsqualität, so daß die geforderte Minimalqualität des Übertragungsmediums nicht garantiert werden kann und dadurch Information verloren werden kann oder beim Empfänger verfälscht ankommt. Für viele Anwendungen, die nur eine vorgegebene Verzögerung erlauben oder die Auslegung des Kanalcodiersystems auf den schlechtesten Fall nicht zulassen, kann deshalb diese Schnittstelle nicht mehr als optimal angesehen werden. Zwar kann die verlorengegangene Information in bestimmten Fällen durch Wiederholungsanforderungen so lange übertragen werden, bis sie dem Empfänger korrekt zur Verfügung steht. Allerdings verhindern oftmals Verzögerungsanforderungen, das Fehlen eines Rückkanals oder fehlende Speicherkapazität das Wiederholen der Information. Dies führt zur Forderung robuster Quellencodierverfahren, um Degradationen oder gar den Ausfall der Anwendung zu vermeiden.

Nachstehend wird kurz auf einige Übertragungs- bzw. Speichermedien eingegangen, die den vorher erläuterten Störungen unterliegen.

Im Mobilfunk ist eine räumliche und/oder zeitliche Qualitätsänderung aufgrund der Entfernung zur Basisstation, der Umgebung und der Bewegung (Fading) unvermeidlich. Zwar wäre ein Rückkanal möglich, bei den meisten Anwendungen entsteht dadurch aber eine nicht tolerierbare Verzögerung; außerdem wird dadurch die Datenrate bzw. der Durchsatz gesenkt.

Im Rundfunk ist ebenfalls eine räumliche Qualitätsänderung aufgrund des Abstands zur Sendeantenne und der Umgebung unvermeidlich. Ist der Empfänger mobil, kommt zusätzlich auch noch die zeitliche Veränderung aufgrund von Umgebungswechsel und Bewegung (Doppler-Effekt, Signalstreuung, Fading) hinzu. Mit Rundfunk wird hier nicht nur Hörfunk bezeichnet, sondern hierunter werden u.a. auch Paging-Systeme sowie alle Arten unidirektionaler Funkdienste gezählt.

Neben dem Mobilfunk und Rundfunk gibt es auch nichtleitungsgebundene, bidirektionale funkbasierte Systeme, die zwar keine Mobilität aufweisen, aber dennoch die Luftschnittstelle zur Übertragung benutzen. Beispiele sind u.a. Wireless Local Loop-Systeme, Wireless Local Area Networks, etc.

Daneben gibt es auch sogenannte portable Systeme, die zwischen den ortsfesten, nicht leitungsgebundenen Systemen und dem Mobilfunk einzuordnen sind. Außer den durch die Mobilität hervorgerufenen Störungen unterliegen diese Systeme den gleichen Störfaktoren wie beispielsweise Mobilfunksysteme. Zwar ist der Empfänger ortsfest, aber jeder Empfänger empfängt die Signale von der Sendestation über einen anderen Kanal, so daß die Bedingungen nicht gleichzeitig für alle Teilnehmer optimiert werden können.

Im Internet kommt es aufgrund heterogener Netzwerke, Blockierung und beschränkter Speicher bzw. Puffer zu langen Verzögerungen und Paketverlusten, die entsprechend der Netzlast zeitlich sehr stark schwanken. Grundsätzlich werden Rückübertragungsverfahren (Anforderung von Wiederholung über Rückkanäle) eingesetzt, was aber bei vielen Echtzeitanwendungen (beispielsweise Internet-Telephonie) zu inakzeptablen Verzögerungen führt.

Auch in ATM-Netzen kommt es aufgrund von Blockierung, Speicherbeschränkungen, Pufferbeschränkungen und heterogenen Übertragungsmedien zu Paketverzögerungen und -verlusten. Auch hier ist eine Rückübertragung (Anforderung von zusätzlicher Information über einen Rückkanal) aufgrund der dadurch hervorgerufenen Verzögerungen inakzeptabel.

Auch in anderen Netzen und Übertragungsmedien sind ähnliche Degradationen möglich. Beispiele dafür sind der Satellitenfunk, der Richtfunk, die Modemübertragung, der Satellitenmobilfunk usw.

Auch bei der Speicherung digitaler Daten kann oft aufgrund der Struktur des Speichermediums keine gleichbleibend hohe Qualität garantiert werden (fehlerhafte Speicherbereiche, Nachlassen von Magnetisierungen, Leckströme bei Halbleiterspeichern, Abnutzung). Hier muß zwischen örtlichen Fehlerstellen (Materialfehler) und zeitlichen Fehlermöglichkeiten unterschieden werden, wobei hier auch das Langzeitverhalten eine Rolle spielt.

Im folgenden werden Signale betrachtet, die für die Übertragung digitalisiert werden. Häufig enthalten solche Signale aufgrund ihrer Korrelationseigenschaften viel Redundanz. Diese Redundanzen werden durch Quellencodier-Algorithmen weitgehend entfernt. Dadurch sind jedoch binär codierte Bitströme erheblich anfälliger gegenüber vorher angeführten Übertragungsfehlern.

Sprache wird meist in bidirektionaler Verbindung zur Kommunikation eingesetzt. Deshalb sind die maximalen Verzögerungszeiten stark eingeschränkt und Rückübertragungen meist nicht möglich. In Sprachsignalen steckt im allgemeinen viel Redundanz und psychoakustische Irrelevanz. Durch Quellencodierung kann zwar viel Redundanz beseitigt werden, jedoch steigt damit auch die Anfälligkeit gegenüber Fehlern. Ähnliches gilt für Audiosignale. Werden Signale mittels Rundfunk übertragen, so ist keine Paketwiederholung möglich.

Bilder haben aufgrund örtlicher Korrelationen meist viel Redundanz. Nach der Codierung sind sie zwar annähernd redundanzfrei, können aber bei fehlerhafter Übertragung nicht rekonstruiert werden. Bei Video treten zu den örtlichen Korrelationen noch zeitliche hinzu. Aufeinanderfolgende Einzelbilder werden von vorhergehenden Bildern prädiziert. Tritt ein Fehler auf, so setzt sich dieser aufgrund falscher Prädiktionsgrundlage meist auch in der Zeit fort.

Auch andere Signale, die auf eine hier nicht näher spezifizierte Art und Weise codiert werden, wie Text, Meßsignale etc., können u.a. aufgrund starker Komprimierung sehr fehleranfällig sein.

Somit ist das Verfahren gemäß der Erfindung in vielen Bereichen, Kombinationen und Varianten einsetzbar ist. Erstens kann jedes Signal über jedes einzelne Medium übertragen werden. Zweitens kann jedes einzelne Signal über heterogene Medien übertragen werden und drittens können codierte Signale zusammengefaßt (Multimedia) und über einzelne oder heterogene Netzstrukturen übertragen werden.

Bisher wird die Übertragung von Signalen über die angeführten Kanäle so gelöst, daß die Bitfehler-, Paketfehler- oder Paketverlustwahrscheinlichkeit auf dem Kanal minimiert wird. Dies geschieht durch den Einsatz von Kanalcodierung; jedoch muß dabei ein bestimmter Teil der zur Verfügung stehenden Bandbreite für diese gezielt eingesetzte Redundanz aufgewendet werden.

Allerdings ist die Dimensionierung der Kanalcodierungsrate nur optimiert für einen bestimmten Kanalzustand. Ändert sich aufgrund der vorher genannten Qualitätsschwankungen der Kanalzustand, dann ist die Optimalität der Anpassung nicht mehr gegeben. Bei zu niedriger Coderate (Coderate $= \dfrac{\text{Infobits}}{\text{Infobits} + \text{Redundanzbits}}$), d.h. zu viel Redun-danz, wird ein zu großer Anteil für die Redundanz verbraucht; die Qualität könnte jedoch durch die Zuteilung von mehr Bits für die Quellencodierung der Anwendung erheblich besser sein. Bei zu wenig Redundanz kommt es zu Bit- und Paketfehlern, wodurch die Anwendung oft extrem verschlechtert wird oder ganz ausfällt.

Auch bei Anwendungen, bei denen Daten über die oben erwähnten Kanäle übertragen werden sollen, ergeben sich Forderungen an die Kanalcodierung. So muß beispielsweise für viele redundanz- und irrelevanzreduziert codierte Anwendungen für bestimmte ausgezeichnete (unbedingt notwendige) Informationen im Bitstrom eine absolut fehlerfreie Übertragung vorausgesetzt werden. Beispiele dafür sind Modus-Bits, Huffman-Tabellen, der Anfang eines mit variablen Längencodes (VLC) codierten Blocks oder Längeninformationen, wie beispielsweise Anzahl der Symbole, Blocklänge etc., die oft Minimalvoraussetzung für die Funktionsfähigkeit von Signalverarbeitungsalgorithmen, wie beispielsweise bei der Quellendecodierung, sind.

Um die vorstehend beschriebenen Probleme zu lösen bzw. die sich daraus ergebenden Forderungen zu erfüllen, sind aus dem Stand der Technik mehrere Lösungsansätze bekannt, die bei der Codierung eingesetzt werden können.

Bei einer fehlerrobusten Quellencodierung wird so codiert, daß bei Bitfehlern oder Paketverlusten noch eine akzeptable Qualität decodiert werden kann. Die Qualität ist dann oft von der Decodierkomplexität (beispielsweise Fehlererkennungsmaßnahmen, Wahl von Kanalcodes unterschiedlicher Komplexität) abhängig. Nachteilig wirkt sich aber hier der Verlust an Kompressionseffizienz aus. Außerdem sind solche Verfahren immer mit großen Qualitätseinbußen verbunden, wenn sich der Kanal sehr stark verschlechtert.

Die vorstehend angeführten Probleme können durch dynamische Anpassung der Rate der Kanalcodierung an die Kanalqualität beseitigt werden. Jedoch sind für die Verwendung solcher Mechanismen mehrere Voraussetzungen unabdingbar. Insbesondere muß der Kanalzustand vor der Codierung beim Sender bekannt sein. Somit darf sich der Kanal nicht zu schnell ändern, und es muß ein Rückkanal vorhanden sein. Wenn ein Sender mehr als einen Empfänger versorgt, ist dieses Szenario ausgeschlossen.

Alle Verfahren, die eine Anpassung der Kanalcodierung an die Quellencodierung vorsehen oder die ein Verfahren zur gemeinsamen Quellen- und Kanalcodierung vorsehen, sind immer sehr speziell auf die Anwendung ausgerichtet und an den Kanal angepaßt. Eine einheitliche Schnittstelle geht somit verloren. Außerdem sind solche Verfahren in der Regel sehr komplex.

Durch ein Aufteilen von Anwendungen in verschiedene Hierarchieebenen und durch einen ungleichmäßigen Fehlerschutz können verschieden wichtige Ebenen je nach momentaner Kanalqualität decodiert werden. Meistens sind solche Empfänger jedoch sehr komplex, da jede Stufe für sich decodiert werden muß. Außerdem ist die Anzahl der Stufen meist klein, oft auf zwei beschränkt, so daß den verschiedenen Bedingungen nur bedingt Rechnung getragen wird. In den höheren Hierarchieebenen ist zusätzlich eine gute Fehlerdetektion notwendig. Aufgrund der wenigen Stufen ist meistens auch beim sogenannten Base Layer eine fehlerrobuste Codierung notwendig, um bei Fehlern in der Decodierung genügend fehlerrobust zu sein.

Sowohl aus A. Seeger: "Information theoretical based design of hierarchical channel coding and modulation for mobile radio channels" in Signal Processing Image Communication, Bd. 12, April 1998 (1998-04), Seiten 117-125, XP004121503 als auch aus C. Berrou und P. Combelles: "Digital Television: Hierarchical Channel Coding using Turbo-Codes" in International Conference on Communications (ICC), US, New York, IEEE, 1. Mai 1994 (1994-05-01), Seiten 1255-1259, XP000438701 ist ein Verfahren zur Übertragung quellencodierter Signale bekannt, denen in Gruppen unterschiedliche Wichtigkeiten zugeordnet sind und die in Datenrahmen über den Kanal übertragen werden, wobei auf der Senderseite eine Aufteilung in verschieden wichtige Informationsteileinheiten, d.h. in Hierarchieklassen, vorgenommen wird. Auf der Empfängerseite wird bei diesen bekannten Verfahren eine Auswahl aus den hierarchisch vorliegenden Daten in Abhängigkeit von der momentanen Kanalqualität getroffen (sogenannte "graceful degradation"). Auf der Sendeseite ist im Anschluß an die hierarchische Quellencodierung, durch welche der Hauptanteil der verfügbaren Redundanz auf die Videodaten von hoher Priorität, also von großer Wichtigkeit, und der andere Teil auf die übrigen, also weniger wichtigen Video-Informationsanteile entfällt, zum einen eine Kanalcodierung für die quellencodierten Videodaten hoher Priorität und zum anderen eine Kanalcodierung für die unwichtigeren quellencodierten Videodaten, also für die Videodaten von niedriger Priorität vorgesehen. Hierbei werden bei der Kanalcodierung der Videodaten von hoher Priorität niederratige Codes benutzt, wobei der Euklidische Abstand zwischen den ausgewählten Clusters ziemlich groß ist, wogegen bei der Codierung der Videodaten von niedriger Priorität hochratige Codes verwendet werden, wobei der Euklidische Abstand zwischen den ausgewählten Punkten ziemlich klein ist. Auf der Empfangsseite wird bei diesen bekannten Verfahren aus dem überlagert übertragenen Videodatengemisch zuerst von einem Kanaldecodierer für die Videodaten von hoher Priorität ein Cluster detektiert. Wenn die Kanalbedingungen geeignet sind, dann wählt ein Kanaldecodierer für die niedrige Priorität den ausgewählten Punkt, wobei die Entscheidung über das Cluster benutzt wird. Ein hierarchischer Quellendecodierer decodiert danach entweder die wichtigsten Videodaten oder aber kombiniert beide Datenströme zur vollen Videoinformation, wenn dies die Kanaleigenschaften erlauben. Es ist festzustellen, daß bei diesen beiden bekannten Verfahren also zwei verschiedene Kanalcodes benutzt werden und zwar einer mit einer niedrigen Coderate für die Videodaten der höheren Hierarchieebene (hohe Priorität und Wichtigkeit) und einer mit einer hohen Coderate für die Videodaten der niedrigen Hierarchieebene (niedrige Priorität und Wichtigkeit).

Aus J. Hagenauer: "Rate-Compatible Punctured Convolutional Codes (RCPC Codes) and their Applications" in IEEE Transactions on Communications, Bd. 36, Nr. 4, April 1988 (1988-04), Seiten 389-400, XP002137975 sind RCPC-Fehlerschutzcodes bekannt, bei denen die Coderate innerhalb eines Datenrahmens und während der Übertragung entsprechend den Erfordernissen geändert werden kann. Eine Quellensignal-Wichtigkeitsinformation, eine Kanalzustandsinformation und eine Überprüfungsinformation aus den decodierten Bits lassen sich zur Anpassung des Codier- und Decodieralgorithmus der RCPC-Codes benutzen. Bei einer dynamischen Anpassung der Rate der Kanalcodierung an die Kanalqualität besteht jedoch hierbei die unabdingbare Voraussetzung, daß der Kanalzustand beim Sender bekannt ist. Somit darf sich der Kanal nicht zu schnell ändern. Außerdem muß ein Rückkanal zur Übertragung der jeweils herrschenden Kanalzustandsbedingungen vorhanden sein.

Häufig werden auf fehlerhaften Kanälen bei Paketverlusten Mechanismen zur Paketwiederholung eingesetzt (ARQ; Automatic Repeat Request). Dazu sind wiederum zwei äußerst restriktive Voraussetzung zu erfüllen. Zum einen darf die Rückanforderung nicht die von der Anwendung geforderte maximale Verzögerung überschreiten; zum anderen muß eine bidirektionale Verbindung aufgebaut werden. Zusätzlicher Signalisierungsaufwand und viel Speicherbedarf beim Sender sind weitere einschränkende Faktoren.

Bei der Decodierung können solche Verfahren noch verbessert werden, indem nicht vollständig entfernte Redundanzen bei der Decodierung zur Generierung von a-priori-Wissen oder zur Fehlerverschleierung (Concealment) verwendet werden. Jedoch sind solche Algorithmen immer nur decoderseitig eingesetzt und haben mit dem Codierverfahren an sich nichts zu tun. Auch Kombinationen der oben angeführten Maßnahmen sind möglich, jedoch ergeben sich auch hier immer die bereits angeführten Probleme.

Prinzipiell verfolgen alle bisher bekannten Verfahren immer eine Minimierung der Bitfehlerrate oder der Paketverlust-Wahrscheinlichkeit an der Decoderschnittstelle. Ferner gehen übertragene Pakete komplett verloren oder die Bitfehler sind innerhalb einer Hierarchieebene gleichmäßig verteilt. Auch bei mehreren Hierarchieebenen wird innerhalb einer Ebene eine Minimierung der Fehlerrate angestrebt. Oftmals sind Daten aber nach einem Fehler wertlos, da diese aufgrund von fehlender Information nicht interpretiert werden können. Außerdem sind die Qualitätseinbußen oft weitaus größer, wenn eine Information falsch decodiert wurde, da es dann oft zu Fehlinterpretationen der nachfolgenden Informationen kommt.

In EP 0 798 888 ist ein Verfahren beschrieben, das sehr stark an GSM angelehnt ist und sich unter anderem mit einer speziellen Aufgabe, nämlich einer verbesserten sogenannten "Bad Frame Indication" für GSM beschäftigt. Dazu wird eine Einteilung der Daten in Hierarchie-Ebenen vorgenommen. Über diese Hierarchie-Ebenen wird jeweils ein zweiter Code oder eine ähnliche Maßnahme zur Fehlererkennung gelegt, wobei lediglich die bekannte Möglichkeit der CRC's angeführt ist. Anhand dieses Codes bzw. dieser Maßnahme wird dann eine erfolgreiche oder fehlerhafte Übertragung einschließlich einer Korrektur der jeweiligen Hierarchie-Klasse bestimmt. Die Information über die korrekte oder fehlerhafte Decodierung bestimmter Klassen wird dann zur Bestimmung eines Qualitätsmaßes verwendet, das zur verbesserten "Bad Frame Indication" verwendet wird. Durch die verbesserte "Bad Frame Indication" wird dann durch geeignete Maßnahmen, wie beispielsweise durch "Concealment", eine verbesserte Sprachqualität erreicht.

Somit kann nur eine Einteilung in eine geringe Anzahl an Hierarchie-Klassen erfolgen, da durch den erzeugten Overhead zur Fehlerdetektion ansonsten die Effizienz des Verfahrens nicht mehr gegeben ist. Zur Fehlerdetektion wird stets ein zweiter Code, beispielsweise CRC, benötigt, der die Effizienz und damit die Zahl der Hierarchie-Ebenen auf einige wenige beschränkt. Außerdem ist mit diesem bekannten Verfahren lediglich eine Fehlerdetektion möglich. Ferner wird die Auslegung und die für alle Empfänger erreichbare Qualität vom schlechtesten Empfänger bestimmt. Obendrein unterliegt das Verfahren nach EP 0 798 888 Beschränkungen aus dem Ratenverlust, der sich beispielsweise aus den CRC-Codes ergibt, der Stationarität des Rückkanals etc.

In JP 9-23 214 A ist ein Verfahren beschrieben, das immer von einem sogenannten Header abhängig ist, welcher zur Bestimmung der momentanen Fehlerrate (error discriminator) anhand eines Testpatterns benutzt wird. Das Verfahren nach JP 9-23 214 A ist nur für eine geringe Zahl an Klassen denkbar, da für jede Klasse Header generiert und übertragen werden müssen. Des weiteren ist die Decodierung einer Klasse nur bei korrekter Decodierung des gesamten zugehörigen Headers möglich.

Ferner haben bei diesem bekannten Verfahren die Hierarchie-Klassen immer eine feste Blockgröße und das Verhältnis zwischen Information und Prüfsumme muß in einem Header codiert übertragen werden. Kann beispielsweise der Header nicht vollkommen korrekt decodiert werden, kann mit der ganzen Klasse trotz Kenntnis der Klassenlänge nicht gearbeitet werden.

Bei dem bekannten Verfahren muß auch die Auslegung explizit für den schlechtesten Fall erfolgen. Die erreichbare Qualität wird somit vom schlechtesten Fall definiert; dies bedeutet, daß durch die beschränkte Anzahl der effektiv möglichen Klassen auch die Progressivität beschränkt wird und daher eine Verbesserung nur in wenigen Abstufungen möglich ist. Die Zahl der Abstufungen ist aber durch die Zahl der Hierarchie-Ebenen gegeben.

Bei diesem bekannten Verfahren ist auch immer eine zweite Methode nötig, um die Korrektheit der Daten festzustellen, sei es durch ein Test-Pattern für den Error Rate Discriminator oder durch einen Fehlerdetektionscode oder durch ähnliche Maßnahmen. Bei dem Verfahren nach JP 9-23 214 A wird im wesentlichen ein Error Rate Discriminator in Verbindung mit Test-Pattern verwendet, um die Fehlerrate auf den Kanal während der Übertragung des Test-Patterns zu bestimmen und anhand der bestimmten Fehlerrate die Auswahl der hierarchischen Daten zu steuern. Die Fehlerrate während der Übertragung sagt jedoch nicht deterministisch aus, ob die Daten der zugehörigen Hierarchieklasse fehlerfrei sind, sondern gibt nur über statistische Betrachtungen einen Anhaltspunkt, mit welcher Fehlerrate für diese Hierarchieklasse zu rechnen ist.

Sogar die Header, die nur Information über Klassengrenzen und die zugehörige Kanalcodierungsrate enthalten, werden mit einem Kanalcode mit hoher Redundanz geschützt, da die richtige Decodierung dieser Header unabdingbare Voraussetzung für die Anwendbarkeit des aus der Druckschrift JP 9-23 214 A bekannten Verfahrens ist. Für eine andere Zusammensetzung der Empfängerqualitäten muß die Bestimmung des Fehlerschutzes für die einzelnen Klassen und deren Grenzen wieder neu erfolgen, woraus folgt, daß bei diesem bekannten Verfahren die Adaptivität nicht gegeben ist.

Darstellung der Erfindung

Aufgabe der Erfindung ist es daher, ein qualitativ verbessertes Verfahren zur Übertragung oder Speicherung von codierten Signalen auf fehlerbehafteten Kanälen zur Verfügung zu stellen und eine prinzipiell neue Schnittstelle zu definieren.

Gemäß der Erfindung, die sich bezieht auf ein Verfahren zur Übertragung quellencodierter digitaler Signale, denen bitweise, symbolweise oder in Gruppen unterschiedliche Wichtigkeiten zuordenbar sind, in Datenrahmen über einen Kanal wobei bei der auf der Sendeseite vor einer Kanalcodierung erfolgenden Quellencodierung pro Datenrahmen eine Aufteilung einer Gesamtinformation in beliebig viele verschieden wichtige Informationsteileinheiten, also in sogenannte Hierarchie-Klassen, bitweise, symbolweise oder in Gruppen vorgenommen wird und auf der Empfangsseite in Abhängigkeit von der momentanen Kanalqualität eine Auswahl aus dem hierarchischen vorliegenden Daten getroffen wird, wird diese Aufgabe dadurch gelöst, daß der quellencodierte Datenstrom durch einen einzigen, gleichzeitig Fehlererkennung/-lokalisierung und Fehlerkorrektur ermöglichenden Code derartig kanalcodiert wird, daß auf der Empfangsseite nach einer Kanaldecodierung für jeden empfangenen Datenrahmen eine von der momentanen Qualität des Kanals und/oder der bereitgestellten Decodierkomplexität und/oder der verfügbaren Empfängerkomplexität abhängige Teilmenge der übertragenen Informationsteileinheiten korrekt decodiert werden kann und daß der korrekte Anteil der decodierten Daten aus den Eigenschaften des Decodierverfahrens des Fehlerkorrekturcodes bestimmt werden kann, so daß zur Rekonstruktion des Quellensignals nur die korrekt decodierte Teilmenge der übertragenen Informationsteileinheiten verwendet und zur Anwendung weitergegeben wird.

Die Erfindung ist generell auf jedes Signal anwendbar, für das die oben erwähnte Gewichtung der Daten bezüglich der Qualität zutreffend ist.

Bei dem erfindungsgemäßen Verfahren ist besonders vorteilhaft, daß für jede denkbare Kombination von zu übertragenden Signalen und für jede denkbare Kombination von Kanälen ein Verfahren zur Verfügung gestellt wird, das sich selbst auf den momentanen Kanalzustand adaptiert und damit in Abhängigkeit vom jeweiligen Kanalzustand den Empfang einer bestimmten Qualität ermöglicht, wobei eine einfache Schnittstelle zwischen Quellen- und Kanalcodierung gewährleistet ist.

Vorteilhafte und zweckmäßige Weiterbildungen des Verfahrens nach der Erfindung sowie besonders vorteilhafte Anwendungsmöglichkeiten dieses Verfahrens sind Gegenstand der auf den Anspruch 1 unmittelbar oder mittelbar rückbezogenen Ansprüche.

Kurze Beschreibung der Zeichnungen

Das Verfahren nach der Erfindung und Verwendungsbeispiele davon werden im folgenden unter anderem anhand von fünf Figuren näher erläutert. Es zeigen:

Fig. 1    in einer Blockdarstellung die bisher übliche Schnittstelle zwischen Quellen- und Kanalcodierung,

Fig.2    im Vergleich dazu eine Blockdarstellung einer gemäß der Erfindung ausgeführten Schnittstelle zwischen Quellen- und Kanalcodierung,

Fig.3    ein mögliches Redundanzprofil zur Codierung ungleichgewichteter Daten,

Fig.4    beispielsweise für eine mobile Audioübertragung, ein Blockbild, das die prinzipielle Vorgehensweise veranschaulicht, um aus einem abgetasteten Audio-Zeitbereichssignal basierend auf psychoakustischen Erwägungen ein komprimiertes Datensignal zur Übertragung zu erzeugen, und

Fig. 5    beispielsweise für eine Audio-Rundfunkübertragung (Broadcast) ein Blockbild, das die prinzipielle Vorgehensweise veranschaulicht, um aus einem abgetasteten Audio-Zeitbereichssignal basierend auf psychoakustischen Erwägungen ein doppelt komprimiertes Datensignal zur Übertragung zu erzeugen.

Ausführungsformen der Erfindung

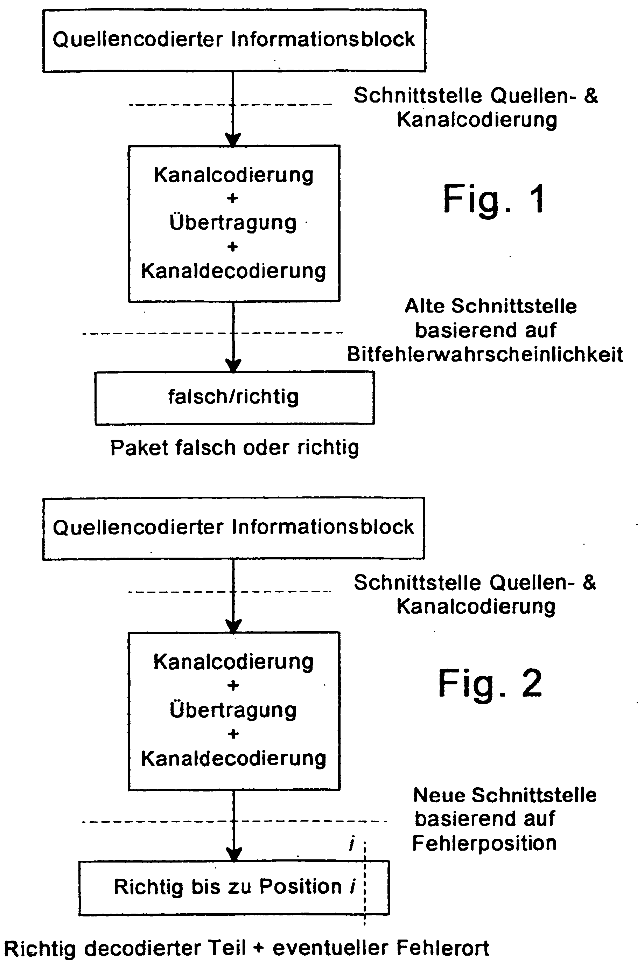

Wie Fig. 2 zeigt, wird nach der Erfindung eine Schnittstelle zwischen Quellen- und Kanalcodierung im Gegensatz zu der bisher verwendeten, vorstehend beschriebenen und in Fig. 1 dargestellten Schnittstelle definiert. Dadurch gehen Bitpakete nicht komplett verloren oder Bitfehler sind nicht willkürlich verteilt. Dadurch ist erreicht, daß ein Teil der Information, wobei die Größe dieses Teils von der momentanen Kanalqualität und/oder der Decodierkomplexität bestimmt wird, zur Anwendung weitergegeben wird, wobei dieser Teil als korrekt angenommen werden kann.

Nach der Erfindung ist eine Codierung vorgesehen, die es einem Empfänger erlaubt, je nach Kanalqualität und/oder Decodierkomplexität mehr oder weniger Teilinformation zu decodieren. Die Decodierkomplexität ist also skalierbar und es wird eine fließende Adaption an den Kanalzustand ermöglicht.

Die Qualität auf der Empfangsseite kann im allgemeinsten Fall durch jede kleinste, zusätzlich zur Verfügung stehende Informationsteileinheit verbessert werden. Die kleinstmögliche Informationsteileinheit ist ein Bit. Die Codierung der Anwendung erfolgt geordnet nach Wichtigkeit der Informationsteileinheiten für die Decodierung der Anwendung.

Diese Wichtigkeit wird im folgenden als Quellenwichtigkeits-Information (Source Significance Information, SSI) bezeichnet. An der Schnittstelle des Empfängers wird somit für jeden Informationsgesamtblock dem Anwendungsdecoder mitgeteilt, wieviele der wichtigsten Informationsteileinheiten für diesen Gesamtblock korrekt decodiert werden konnten.

Im Gegensatz zu den bekannten Verfahren kann mit dem Verfahren nach der Erfindung eine Übertragung zu vielen Empfängern mit unterschiedlicher Kanalqualität gewährleistet werden, wobei jeder einzelne Empfänger eine fehlerfreie Information individueller Größe entsprechend seinen jeweiligen Gegebenheiten (Kanalqualität, Decodierkomplexität, etc.) empfängt. Obendrein ist die Empfangsqualität sehr fein an die Kanalqualität angepaßt. Solange die Codierung so eingesetzt wird, daß auch im schlechtesten Empfangsfall eine Grundinformation decodiert werden kann, ist somit das ganze Spektrum der Empfänger abgedeckt.

Somit wird nicht mehr die Minimierung der Paketverlustrate, der Paketfehler-Wahrscheinlichkeit oder der Bitfehlerwahrscheinlichkeit als Hauptauslegungskriterium benutzt, sondern es wird nach der Erfindung die Fehlerfreiheit eines möglichst großen Teiles der Informationsteileinheiten genutzt, die für die Quellendecodierung am wichtigsten sind.

Das Ziel der Quellencodierung besteht nun ebenfalls (wie bei den bisherigen Verfahren) in einer bestmöglichen Kompression und gleichzeitig im Aufteilen in möglichst viele, verschiedene wichtige Informationsteileinheiten, am besten in einzelne Bits. Die Schnittstelle bleibt einfach und die Aufgaben können sowohl in der Standardisierung, in der Informationstheorie als auch in der Implementierung wieder getrennt behandelt werden, jetzt aber nach dem erfindungsgemäßen Prinzip.

Beispielsweise kann die Anordnung innerhalb eines Informationsgesamtblockes so gestaltet werden, daß die Informationsteileinheiten mit der größten Quellenwichtigkeits-Information zu Beginn stehen und die Informationsteileinheiten mit abnehmender Quellenwichtigkeits-Information weiter hinten stehen. Wenn beispielsweise die Interpretation einer Informationsteileinheit von der Korrektheit einer anderen Informationsteileinheit abhängt, sollte die abhängige Informationsteileinheit weiter in Richtung Blockende codiert angeordnet werden. Beim Verfahren nach der Erfindung wird dann der Fehlerschutz so gestaltet, daß die Position (in Fig. 2 ist dies die Position i) des ersten Fehlers im Übertragungsblock so weit wie möglich hinausgeschoben wird.

In vorteilhafter Weise läßt sich dies beispielsweise dadurch erreichen, daß Codes variabler Rate verwendet werden, deren Rate über die Blocklänge bis auf eine Maximalrate (geringste Redundanz) ansteigt. Beispiele für Codes variabler Rate sind punktierte Faltungscodes, insbesondere ratenkompatible. Zur Decodierung kann ein adaptiver sequentieller Decoder mit gegebener Komplexität (Decodierressource) eingesetzt werden, der nun bis zu einer bestimmten Rahmentiefe decodiert. Das Quellensignal wird aus diesen fehlerfreien Daten rekonstruiert. Bei guten Kanälen wird die Decodierressource nicht aufgebraucht und die Quelle vollständig rekonstruiert. Wird der Kanal schlechter, so ist die Decodierressource vor Ende des Rahmens aufgebraucht. Aus der Stoppstelle des Decoders im Datenrahmen oder anderen geeigneten Lokalisierungskriterien (Decodierressourcenverbrauch, Metrikänderungen, etc.) kann der fehlerfreie Rahmenteil bestimmt werden. Es findet dann eine Teilrekonstruktion der Quelle mit diesem fehlerfreien Datenrahmenteil mit leicht verminderter Qualität statt.

Das Verfahren nach der Erfindung kann durch Anwendung von quellengesteuerter Kanalcodierung, Kanaldecodierung und iterativer Decodierung noch weiter verbessert werden.

Es werden im folgenden einige vorteilhafte Verwendungsbeispiele des Verfahrens nach der Erfindung erläutert.

Das Verfahren nach der Erfindung läßt sich vorteilhaft zur Übertragung von JPEG(Joint Photographic Experts Group; Standard für Stillbildkompression)-Standbildern einsetzen.

Im Zusammenhang mit diesem Ausführungsbeispiel wird im folgenden auf verschiedene Modi der JPEG-Standbild-Kompressionsstandards eingegangen und es wird eine mögliche einfache Erweiterung beschrieben, die die vorher angesprochene neue Schnittstelle in ausgezeichneter Weise nutzt.

JPEG beruht auf einer DCT(Diskrete Cosinus-Transformation)-basierten Codierung von einer Folge von 8 x 8-Pixel-Blöcken, die nur Grauwertinformtion enthalten. Farbbilder bestehen im Prinzip aus drei unabhängigen Grauwertbildern, aus denen sie zusammengesetzt werden können. Somit entspricht die JPEG-Codierung von Bildern der Codierung von drei Grauwertbildern und somit der Codierung von 8 x 8-Pixel-Blöcken, die im folgenden abkürzend als Block bezeichnet sind.

Jeder dieser Blöcke wird durch eine DCT in 64 orthogonale Basissignale umgeformt. Die Gesamtheit der daraus entstehenden 64 DCT-Koeffizienten beschreibt das Ortsspektrum. Diese Transformation ist verlustfrei; das Bild kann aus dem Ortsspektrum rekonstruiert werden. Es wird grundsätzlich noch zwischen dem DC und den AC unterschieden. Der DC beschreibt den Gleichanteil des zu codierenden Blockes, die AC die höherfrequenten Wechselkoeffizienten.

Im Grundmodus (Baseline) folgt nun eine Quantisierung der Koeffizienten, die an die psychooptischen Gegebenheiten des menschlichen Auges angepaßt ist. Durch diese Quantisierung wird die Codierung nun verlustbehaftet, jedoch wird die Datenrate enorm gedrückt (Kompression). Durch eine Lauflängensowie Huffmancodierung werden die restlichen Redundanzen aus den quantisierten Koeffizienten entfernt. Abhängig von seinen Ortsfrequenzen wird aber jeder Block durch eine verschiedene Anzahl von Bits repräsentiert. Diese Blöcke werden nun sequentiell aneinandergereiht und übertragen.

Zu Beginn des Bildes wird noch Steuerinformation wie beispielsweise die Größe des Bildes, die verwendeten Huffman-Tabellen und Quantisierer, oder es werden noch andere spezifische Informationen eingefügt. Tritt ein Übertragungsfehler auf, so ist aufgrund der Huffman- und Lauflängencodierung meist das Bild komplett gestört, die restlichen Bits sind wertlos und durch die fehlende Interpretation nicht zuordenbar. Wird der Übertragungsfehler nicht detektiert, so führen die auf den Decodierfehler folgenden Daten aufgrund von Fehlinterpretation zu Artefakten, die oft die Qualität des Bildes in inakzeptabler Weise verschlechtern.

Durch die Einführung von regelmäßigen Synchronisationsmarken, die nach einer im Bitstrom sonst nicht auftretenden Folge (17 x '0' Bit) auch den momentanen Ort im Bild codiert haben, kann nach Übertragungsfehlern zumindest die Decodierung an dieser nun bekannten Stelle fortgesetzt werden. Wenige Synchronisationsmarken erhöhen die Fehlerrobustheit jedoch kaum; viele Marken (beispielsweise nach jedem Block) erhöhen den Overhead drastisch, da die eindeutige Bitfolge und eine Resynchronisationsinformation mitcodiert werden. Außerdem werden häufig fehlerhafte Daten dargestellt, was die Qualität stark beeinträchtigt.

JPEG beinhaltet in einem weiteren Modus die Möglichkeit einer hierarchischen Codierung. Dabei wird das Originalbild in beiden Dimensionen in Vielfachen von 2 unterabgetastet. Die größenreduzierten Bilder werden dann mit dem vorher beschriebenen Verfahren (DCT, Quantisierung und Entropiecodierung) codiert und danach wieder vergrößert. Dieses niedrigaufgelöste Bild dient nun als Prädiktionsgrundlage. Es wird ein Differenzbild zur nächsten Größe erzeugt und dieses Differenzbild wird wieder nach dem Verfahren des Grundmodus codiert. Dies kann mehrmals fortgesetzt werden.

Die verschieden aufgelösten Ebenen werden nun sequentiell der Wichtigkeit nach übertragen. Dies führt zu einer groben Wichtigkeitsbildung, wobei jedoch die Anzahl der Auflösungsschichten meist auf einige wenige beschränkt ist. Die Kompressionseffizienz sinkt zwar, bleibt aber immer noch in einem tolerierbaren Bereich. Die Anzahl der Bits variiert wieder stark innerhalb der Ebenen.

In einem weiteren Modus erlaubt JPEG eine progressive Codierung. DCT und Quantisierung werden in identischer Weise wie beim Grundmodus verwendet. Jedoch werden anschließend die einzelnen Bildkomponenten nicht in einem Durchlauf in eine sequentielle Reihenfolge gebracht, sondern in mehreren Durchläufen. Im ersten Durchlauf erfolgt nur die Codierung der niederfrequenten Koeffizienten, eventuell auch nur der wichtigsten Bits dieser PCM-codierten Koeffizienten.

In weiteren Durchläufen wird so weit verfeinert, bis eine Qualität entsprechend der durch die Quantisierung gegebenen Bildqualität gegeben ist. Die Gesamteffizienz ist aufgrund fehlender Redundanzcodierung (Huffman- und Lauflängencodierung) aber schlecht (geringe Kompression). Zusätzlich benötigt der Empfänger einen Speicher für das komplette Bild in quantisierter DCT-Darstellung.

Nachdem die Übertragung im drahtlosen Bereich im allgemeinen datenrahmenbasiert geschieht und der Empfänger eine Synchronisation auf diese Rahmen zur korrekten Kanalschätzung und Decodierung grundsätzlich benötigt (synchroner Empfang), können meist integere Paketgrenzen vorausgesetzt werden. Die Größe solcher Pakete variiert von wenigen hundert Bits (beispielsweise bei GSM: 114 Bit) bis zu mehreren tausend (beispielsweise bei DVB: 1504 Bit). Im allgemeinen können diese Pakete zur Übertragung ausgenutzt werden, wobei auch eine Bündelung von Paketen möglich ist, um größere Pakete in der Anwendung zur Verfügung zu haben (beispielsweise bei GSM: 4 x 114 = 456 Bit).

Diese Pakete werden nun genutzt, um einen durch Kanalcodierung geschützten Informationsrahmen zu übertragen. Bisher wurde eine Minimierung der Paketverlustquote, Paketfehler-wahrscheinlichkeit oder der Bitfehlerwahrscheinlichkeit angestrebt, was sich aber aufgrund der genannten Nachteile nicht als optimal herausstellt, vor allem dann, wenn der Kanal zeitlichen und/oder örtlichen Schwankungen unterliegt.

Der Übertragungskanal kann nun aus jeglichem vorstellbaren Kanal bestehen, der Bitfehler oder -auslöschungen erzeugt. Beispiele dafür sind Paketverluste im Internet, die durch Interleaving zu einzelnen Auslöschungen gespreizt werden, der Rundfunkkanal, der Mobilfunkkanal und viele mehr.

Diese vom Übertragungssystem zur Verfügung gestellten Pakete werden nun für quellencodierte Information und für die Redundanz der Kanalcodierung genutzt. Im allgemeinen wird gleichmäßig über ein Informationspaket Redundanz verteilt, so daß Bitfehler zufällig gleichverteilt irgendwo im quellencodierten Informationspaket auftauchen können. In diesem Zusammenhang wird auf Fig. 1 hingewiesen.

Anhand des JPEG-Beispiels soll dies nun näher erläutert werden. Um die Vorstellung eines zeitlichen Ablaufes besser verdeutlichen zu können, wird von einem Motion-JPEG ausgegangen, d.h. es wird eine Folge von Einzelbildern geschickt, so daß von Video gesprochen werden kann. Beim JPEG-Grundmodus wird der codierte Bitstrom in entsprechende Rahmen aufgeteilt und übertragen. Tritt in irgendeinem Übertragungsrahmen ein 9itfehler auf, so ist das restliche Bild meist verloren, da die Daten aufgrund der variablen Längencodierung nicht mehr zugeordnet werden können. Bei einer Abfolge von Bildern kann meist erst wieder auf das darauffolgende Bild synchronisiert und dieses nach dem Suchen eines Startcodes decodiert werden. Eine Quellendecodierung solcher Rahmen führt zu einer katastrophalen Qualität.

Durch den Einsatz von eindeutigen Resynchronisationsmarken nach einer definierten Anzahl von Blöcken kann die Decodierung schneller wieder fortgesetzt werden. Dennoch fallen nach einem fehlerhaften Übertragungsrahmen die Blöcke bis zum nächsten Marker aus. Eine Marke pro Block erhöht den Overhead unverhältnismäßig stark; außerdem sind fehlerhafte Blöcke trotzdem verloren. Es gibt keine expliziten Mechanismen wie beispielsweise CRCs (Cyclic Redundancy Check) zur Fehlererkennung und vor allem keine Fehlerlokalisierung in JPEG.

Fehler werden zwar häufig durch nicht gültige Codewörter oder falsch gesetzte Resynchronisationsmarken erkannt, jedoch erfolgt die Fehlererkennung meist erst an einer späteren Bitstelle. Somit ist keine Fehlerlokalisierung möglich, und zum Vermeiden einer falschen Darstellung müssen die kompletten Daten zwischen zwei Resynchronisationsmarken verworfen werden. Um eine fehlerhafte Darstellung und die damit verbundenen Qualitätseinbußen zu vermeiden, wirkt sich jedoch vorteilhaft eine Fehlererkennung auf Kanalcodierungsseite durch das Übertragungssystem aus; der komplette Übertragungsrahmen ist aber dann für die Anwendung verloren.

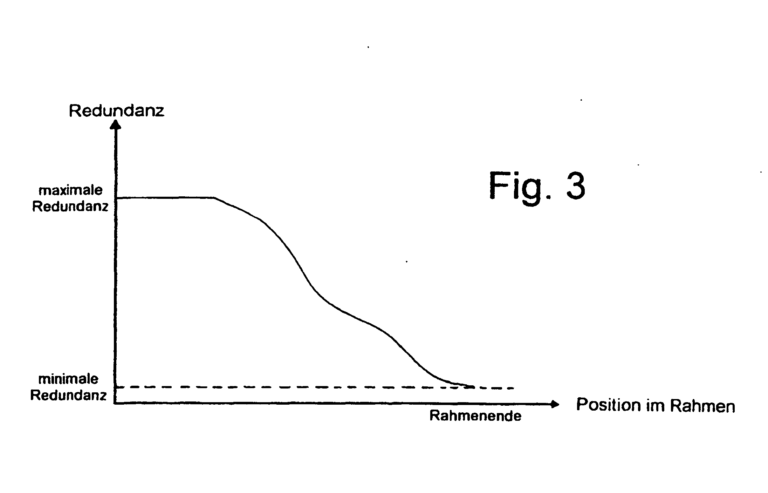

Eine angepaßte Kanalcodierung kann auf verschiedene Weise realisiert werden. Gut geeignet für die verschiedensten Anwendungen ist ein Redundanzprofil entsprechend Fig. 3, d.h. mit abfallender Redundanz von Rahmenbeginn zum Rahmenende. Eine Codierung mit punktierten Faltungscodes mit kleinem Gedächtnis und Viterbi-Decodierung eignet sich relativ gut für einen derartig codierten Rahmen. Zusätzlich müssen aber CRCs zur Fehlererkennung eingestreut werden, um eine Lokalisierung des Decodierfehlers zu ermöglichen.

Besser geeignet bei gleichem Redundanzprofil, gleichem Bandbreitenbedarf und gleicher Decodierkomplexität ist jedoch ein Faltungscode mit großem Gedächtnis und sequentieller Decodierung, beispielsweise anhand des Stack- oder Fano-Algorithmus. Bei diesem Verfahren ist eine Fehlerlokalisierung im Decoder anhand der Eigenschaften des Decoders möglich; die Fehlerlokalisierung durch CRCs ist unnötig. Zusätzlich ist eine Lokalisierung bitgenau möglich, im Gegensatz zum eingestreuten CRC, der immer nur einen kompletten Teilblock als falsch oder richtig deklariert. In diesem Zusammenhang wird auf Fig. 2 hingewiesen.

Dadurch kommt es dann auch vor, daß die wichtigste Information beispielsweise in der Mitte des Übertragungsrahmens angeordnet wird, und zwar aufgrund der fehlenden Anpassung an das Übertragungsrahmenformat.

Ausgehend von diesen Erläuterungen wird im folgenden ein Übertragungsrahmen der Länge N definiert. Nach der Übertragung liefert ein nach obigen Ausführungen ausgelegtes Verfahren einen Teilrahmen der Länge $T_i \leq$ N zurück, der als fehlerfrei angesehen werden kann. Die Länge $T_i$ ist abhängig vom momentanen Kanalzustand, der der Übertragung des Gesamtrahmens i zugrunde liegt, und von der momentanen Decodierkomplexität. Beim Verfahren nach der Erfindung wird im Übertragungssystem eine Schnittstelle nach der beschriebenen Art definiert; die Anwendung sollte zweckmäßigerweise eine entsprechende Codierung vornehmen.

Bei der hierarchischen JPEG-Codierung ist die Ordnung der Wichtigkeit im allgemeinen nicht an das Rahmenformat angepaßt. Die hierarchisch codierten Ebenen folgen im Bitstrom der Wichtigkeit nach geordnet, zuerst die binäre Darstellung der Grundebene und dann die weiteren Ebenen. Somit kommt es zu ähnlichen Problemen wie im Grundmodus, wenn Übertragungsfehler auftreten, vor allem in der niedrigstaufgelösten Ebene, von der die nächsten Ebenen prädizieren.

Im progressiven Modus erfolgt die Codierung ebenso im Bitstrom der Wichtigkeit nach, jedoch kann nun jedes einzelne Bit eine Qualitätssteigerung bringen. Diese Codierungsarten eignen sich für das erfindungsgemäße Verfahren der Quellen- und Kanalcodierung. Es erfolgt jedoch keine Anpassung an das Rahmenformat der Übertragung.

Zusätzlich ist bisher kein Fehlerschutz bekannt, der auf zeitlich bzw. örtlich variierende Übertragungsbedingungen in der Art eingehen kann, daß sich der Ort des ersten Fehlers für jeden Kanalzustand so weit wie möglich an das Rahmenende verschieben läßt und zusätzlich für jede Empfangsbedingung lokalisierbar ist.

Durch Umordnung in das Format des Übertragungsrahmens, wobei die wichtigsten Ebenen bzw. Bits immer am Beginn des Rahmens zu finden sind, wäre eine Abstufung sowohl bei der hierarchischen als auch bei der progressiven Codierung möglich. Bei der hierarchischen Codierung hat man nun aber nur eine diskrete Abstufung in Ebenen (meist zwei); bei der progressiven Codierung könnte jedes Bit innerhalb eines Rahmens zusätzliche Information bringen.

Jedoch ist beim Verlust einer zur progressiven Decodierung notwendigen Information in einem früheren Rahmen die Decodierung in einem späteren Rahmen nicht mehr komplett möglich. Die Zusatzinformation kann nicht mehr voll ausgenutzt werden. Durch diese genannten Codierungsarten ist auch ein erhöhter Speicherbedarf im Empfänger notwendig, da zur vollständigen Verarbeitung das komplette Bild gespeichert werden muß.

Somit ist es notwendig, eine Quellencodierung mit von vorne nach hinten im Rahmen abfallender Wichtigkeit zu finden. Zusätzlich darf keine Abhängigkeit zwischen den Daten, die in verschiedenen Rahmen übertragen werden, bestehen, solange die Information, von der folgende Datenrahmen prädizieren, nicht mit Sicherheit auch bei schlechten Empfangsbedingungen korrekt decodiert werden kann. Diese Information, die unbedingt notwendig ist, sollte relativ klein gehalten werden, um eine möglichst granulare Abstufung der Quelleninformation zu ermöglichen.

Es wird somit eine auf dem JPEG-Grundmodus basierende Codierung betrachtet. Jeder der einzelnen Pixel-Blöcke j liegt in codierter Form vor, wobei die Huffman-Tabellen sowohl für die differentiell codierten DC als auch für die als Ereignisse lauflängencodierten AC bekannt sind. Ein Ereignis ist im folgenden das Auftreten eines Nicht-Null-Koeffizienten im Ortsspektrum; Amplitude, Anzahl der Nullkoeffizienten vor diesem Koeffizienten und ein Flag, das aussagt, ob dies der letzte Koeffizient in diesem Block war, werden in einem Code zusammengefaßt.

Die einzelnen Koeffizienten sind lauflängen- und huffmancodiert. Der DC ist zwischen den einzelnen Blöcken eines Übertragungsrahmens differentiell codiert, was zusätzlich die Bitrate reduziert. Ausgehend von diesen Daten wird nun eine Anpassung an das Rahmenformat der Übertragung erläutert. Es wird davon ausgegangen, daß die Rahmenlänge N des Übertragungssystems dem Encoder bekannt ist. Das Vorgehen, die Blöke gewichtet in das Rahmenformat zu packen und anschließend wieder entsprechend zu decodieren, wird im folgenden dargestellt.

1. Es wird davon ausgegangen, daß alle Blöcke bis zum Block $J_i$-1 in den vorherigen $i$ - 1 Rahmen bereits übertragen sind, d.h. der nächste zu übertragende Block ist $J_i$. $J_i$ ist also die kumulierte Zahl der JPEG-Blöcke bis zum Übertragungsrahmen i. Für diesen Block $J_i$ wird die differentielle Codierung des DC rückgängig gemacht und neu codiert.

2. In einen Übertragungsrahmen i von konstanter Länge $N_i = N$ werden so viele codierte Blöcke $A_i = J_{i+1} - J_i$ wie möglich gepackt. Die Anzahl der Blöcke $A_i$ in diesem Rahmen i hängt von der Länge $L_j$ der einzelnen Blöcke ab. Zusätzlich wird noch ein Feld codiert übertragen, das die Anzahl $A_i$ der Blöcke innerhalb dieses Übertragungsrahmens definiert. Dieses Feld, das eine Art relative Adresse innerhalb des Bildes darstellt, ist die einzige Information, die sicher für jeden Übertragungsrahmen ankommen muß, da sonst die Zuordnung der Blöcke im Bild verloren geht. Dieses Feld hat die Länge $M_i = M$ in Bits; es können also maximal $2^M$ Blöcke in einen Übertragungsrahmen gepackt werden. Es muß also gelten:

$$\sum_{j=J_i}^{J_{i+1}-1} L_j \;\leq\; N - M_i \;=\; N - M\,.$$

3. Der Übertragungsrahmen muß nicht notwendigerweise vollgepackt sein, da die Summe der Längen $L_j$ innerhalb des Rahmens i möglicherweise kleiner als N ist. Die restlichen Bits müssen also aufgefüllt wären, im einfachsten Fall mit Stopfbits. Verbesserte Methoden wie die codierte Übertragung eines Teils des durch die Quantisierung verlorengegangenen Differenzbildes oder ähnliches ist ebenfalls möglich.

4. Nach Schritt 2 stehen nun die $A_i$ Blöcke fest, die im Rahmen i übertragen werden. Nun erfolgt eine Anordnung der Information in der Art, daß die wichtigste Information am Anfang des Blockes angeordnet wird und mit abfallender Wichtigkeit die Daten der codierten Blöcke im Rahmen nacheinander angeordnet werden. Information im hinteren Teil des Rahmens kann ohne das Bekanntsein der Informationsbitfolge im vorderen Teil nicht decodiert werden. Ein Bitfehler würde zu katastrophalen Auswirkungen führen. In den folgenden Schritten wird nun die Anordnung der Daten gezeigt.

5. Zunächst wird das Bitfeld, das die Anzahl der Blöcke beinhaltet, an den Rahmenanfang geschrieben.

6. Anschließend folgt der nicht prädiktiv codierte DC des ersten Blockes, dann folgen die differentiell codierten DC der restlichen Blöcke.

7. Dann folgen die huffmancodierten AC in der Weise, daß zunächst von jedem Block immer das erste lauflängen- und huffmancodierte Ereignis eingeschrieben wird. Dann folgt von jedem Block das zweite Ereignis, usw., so lange bis ein Block kein Ereignis mehr hat, also das sogenannte EOB(End of Block)-Symbol erreicht ist. Für diesen Block werden dann keine Ereignisse mehr auf den Bitstrom geschrieben.

Dies wird so lange fortgesetzt, bis der letzte Block vollkommen im Rahmen eingeschrieben ist. Die restlichen Daten werden mit Stopfbits, mit einem Teil des codierten Quantisierungsfehlers oder ähnlicher Information, die nutzbringend zur Qualitätsverbesserung verwendet werden kann, aufgefüllt.

8. Dieser Rahmen wird komplett zur Übertragungsschicht weitergegeben und in der angesprochenen Weise mit Fehlerschutz versehen. Auf die Kanalcodierung und -decodierung wird hier nicht weiter eingegangen. Der Quellendecoder erhält nun für jeden Rahmen einen Teilrahmen der Länge $T_i$, der vom Kanalcoder als richtig deklariert wurde (Fig. 2). Der restliche Teil des Rahmens wird bei der Quellendecodierung nicht verwendet.

9. Ausgehend von diesem erhaltenen Teil des Pakets wird nun die Quellendecodierung in der Art durchgeführt, daß zunächst die Anzahl der im Rahmen enthaltenen Blöcke decodiert wird. Anschließend werden alle DC decodiert und schließlich solange die AC-Ereignisse decodiert, bis das Ende des Teilblocks erreicht ist. Dieses Ende ist durch die Bitstelle gegeben, bis zu welcher der Kanaldecoder richtig decodiert hat.

Somit können zumindest die niederfrequenten Koeffizienten decodiert werden. Die nicht mehr decodierbaren höherfrequenten Koeffizienten werden vor der inversen DCT auf "0" gesetzt. Schließlich werden die Blöcke durch eine inverse DCT rekonstruiert. Das Fehlen höherer Spektralanteile wirkt sich nicht allzu störend aus, da das Auge bei den höherfrequenten Anteilen weniger empfindlich ist. Somit ist die Qualität des decodierten Bildes von den Längen der Teilrahmen $T_i$ abhängig, jedoch kommt es immer zu einer Grundqualität. Ein Komplettausfall ist nicht möglich.

Eine Codierung in anderer Art und Weise, die die Daten in ähnlicher, eventuell auch weniger komplexen Art und Weise umsortiert, ist möglich, aber dann weniger effektiv. Auch eine andere Codierung, die zu der angesprochenen Gewichtung führt, ist denkbar, soll aber hier nicht weiter diskutiert werden.

Das Verfahren nach der Erfindung kann in vorteilhafter Weise auch zur Sprachübertragung über GSM (Global System for Mobile Communication) eingesetzt werden. GSM ist heute ein weltweites System, daß vor allem für die Sprachkommunikation mobiler Teilnehmer verwendet wird. Dabei wird eine relativ fehlerrobuste Sprachcodierung und ein ungleichmäßiger Fehlerschutz eingesetzt.

Für alle aktiven Teilnehmer steht alle 20 ms ein Rahmen von 456 Bit zur Verfügung, in dem ein geschützter Sprachrahmen gesendet wird. Jedoch ist aufgrund der Besonderheit des Mobilkanals eine ständige Schwankung des Empfangssignals unvermeidlich. Zum einen bestimmen Fading-Einflüsse kurzzeitige Signaleinbrüche. Zum anderen kommt es durch Abschattungen und dem räumlichen Abstand zur Sendeantenne zu starken Unterschieden im Signalpegel.

Die Codierung des gesendeten Sprachrahmen ist dabei für jeden Teilnehmer und zu jedem Zeitpunkt identisch, um Komplexität und Signalisierungsverkehr klein zu halten, d.h. es findet keine Anpassung auf die für den einzelnen Teilnehmer herrschenden Übertragungsbedingungen statt. Somit kommt es trotz ungleichmäßigem Fehlerschutz (Aufteilung in zwei geschützte Klassen, und zwar eine mit und eine ohne Fehlererkennung, und eine ungeschützte Klasse) bei tiefen Schwundeinbrüchen, einer Abschattung, starken Interferenzstörungen oder bei großer räumlicher Entfernung zu einem Totalausfall.

Die Qualität des Sprachsignals, deren objektive Beurteilung meist anhand des segmentalen Signal/Rausch-Verhältnisses $SNR_{SEG}$ erfolgt, ist jedoch sehr abhängig davon, wo die Fehlerstelle im Block auftritt. Dabei kann die Grenze zwischen gut und schlecht nicht an einer bestimmten Bitstelle im 260 Bit langen Sprachblock gesetzt werden; denn es gilt: je mehr Bit decodiert werden, desto besser wird die Qualität, obwohl die Auslegung des GSM-Kanalcodiersystems nicht anhand dieser Prinzipien erfolgte und daher nicht optimal ist. Somit wäre bei einer Auslegung des Quellencodierverfahrens nach den erläuterten Prinzipien eine weitere Qualitätsverbesserung im GSM-System möglich.

Besonders gut eignet sich dabei ein Fehlerschutz, der zur Codierung einen Faltungscode mit sehr großem Gedächtnis verwendet und zusätzlich ein vom Blockanfang zum Blockende abfallendes Ratenprofil hat.

Mit Hilfe eines sequentiellen Decoders kann eine Decodierung erfolgen, die eine Abschätzung über die Position des ersten Fehlers ermöglicht. Dabei kann ein Teil der Information als richtig decodiert angenommen werden, wobei die Größe dieses Teiles vom momentanen Kanalzustand und/oder der Decodierkomplexität abhängt. Zusätzlich kann mit Hilfe dieses Decoders die Qualität des Signals von der Decodierkomplexität abhängig gemacht werden. Bei wenig gespeicherter Energie in einem Akku kann eine Decodierung mit wenig Komplexität immer noch eine akzeptable Qualität erreichen.

Wie bereits erwähnt, könnte durch Einführung eines neuartigen Sprachcodierers, der die genannten Eigenschaften der Schnittstelle noch besser ausnutzt, die Qualität weiter verbessert werden. Die wichtigsten Daten wie beispielsweise Modi-Bit, Einträge aus Codebüchern in ACELP-Verfahren usw. können bei entsprechender Auslegung des Kanalcodiersystems durch die angesprochene Codierung und Decodierung als korrekt angenommen werden. Beim Decoder ergibt sich dann die Möglichkeit, durch zusätzliche Komplexität (z.B. weiterer Aufwand an Energie) eine bessere Qualität zu erreichen.

Das Verfahren nach der Erfindung kann in vorteilhafter Weise auch zur Videoübertragung über ATM (Asynchroner Transfer-Modus) eingesetzt werden. ATM ist für verschiedene Anwendungen vorgesehen, beispielsweise für Bildtelephonie, Videokonferenz, Standardfernsehen oder HDTV (High Definition TV).

Um die Bandbreite in ATM-Netzen optimal ausnützen zu können, wird statistisches Multiplexing verwendet, d.h. jede Anwendung kann eine variable Bitrate haben. Im Mittel wird dadurch eine bessere Qualität erreicht, als wenn alle Anwendungen mit konstanter Bitrate übertragen werden müßten. Falls die Summe der Bitraten jedoch größer als die insgesamt zur Verfügung stehende Bitrate auf dem Übertragungsmedium ist, kommt es zu Paketverlusten, da die Übertragungsleitung blockiert ist.

Es wäre aber eine Verschwendung von Ressourcen, das System auf die Summe der maximalen Bitraten jeder einzelnen Anwendung auszulegen. In diesem Fall wird dann ein sehr erheblicher Teil der zur Verfügung stehenden Bitrate im Mittel nicht verwendet, und zwar nämlich immer dann, wenn die Anwendungen nicht ihre maximal benötigte Bitrate anfordern. Dieser Teil könnte eigentlich zur Übertragung von Information genutzt werden.

Jedoch kann mit den vorher beschriebenen Methoden trotz solcher Blockierfälle eine akzeptable Qualität decodiert werden. Durch den Einsatz eines Quellencodierverfahrens mit unterschiedlicher Gewichtung der Informationsteileinheiten und eines Interleaving-Verfahrens kann nun im Mittel eine bei weitem höhere Qualität erreicht werden. Durch dieses Interleaving werden die Paketverluste in Einzelauslöschungen umgewandelt (Auslöschungskanal).

Die Kanalcodierung kann beispielsweise mittels eines Codes mit hohem Gedächtnis und einem innerhalb des Blocks abfallenden Ratenprofil realisiert werden. Die Decodierung erfolgt mit einem sequentiellen Decoder. Das Interleaving stellt aufgrund der meist hohen Datenraten keine große Einschränkung bezüglich der Verzögerungen dar. Durch eine gesteigerte Decodierkomplexität des sequentiellen Decoders kann die Empfangsqualität ebenfalls verbessert werden.

Für andere Netze, die statistisches Multiplexing nutzen oder Paketverlusten unterliegen, wie beispielsweise das Internet, können ähnliche Verfahren verwendet werden.

Das Verfahren nach der Erfindung kann in vorteilhafter Weise auch zur Fernsehrundfunkübertragung eingesetzt werden. Beim Fernsehrundfunk werden mehrere örtlich unterschiedlich gelegene Empfänger versorgt. Diese Empfänger haben somit verschiedene Empfangsbedingungen, d.h. sie finden ein unterschiedliches Signal/Rausch-Leistungsverhältnis (SNR) vor.

Um auch den Nutzern in Randzonen, die also weit vom Sender entfernt sind, eine gute Qualität bieten zu können, muß ein relativ großer Anteil an Kanalcodierung verwendet werden. Für die meisten anderen Nutzer, die näher zum Sender sind, wird somit das System überdimensioniert. Durch eine hierarchische Codierung in diskreten Layern (meist 2) ist zwar eine Abstufung möglich, jedoch wird dann eben nur zwischen diskreten (meist 2) Klassen unterschieden.

Durch das angegebene Verfahren, in dem bei dieser Verwendung die Fehlerposition an der Schnittstelle zwischen Kanaldecodierung und Quellendecodierung abhängig vom Ort des jeweiligen Empfängers ist (insofern, als der Ort des Empfängers die Wahrscheinlichkeitsverteilung bestimmt, mit der der erste Bitfehler an einer bestimmten Bitstelle im Rahmen auftritt), kann somit entsprechend der Erfindung eine granulare Abstufung entsprechend dem Ort getroffen werden. Gemittelt über alle Nutzer, ergibt sich somit eine Qualitätssteigerung.

Das Verfahren nach der Erfindung läßt sich in vorteilhafter Weise auch bei der sogenannten PCM-Übertragung verwenden. Die PCM-Übertragung ist ein sehr einfaches, sehr weit verbreitetes Quellen-Codierverfahren. Bei der PCM-Ubertragung wird ein durch seine analogen oder digitalen Abtastwerte dargestelltes Signal mit einer bestimmten Wortbreite quantisiert; diese quantisierten Abtastwerte werden binär codiert und dann übertragen. Die binäre Codierung wird dabei meist so gewählt, daß die größte mit dieser Wortbreite darstellbare binäre Zahl der größten Quantisierungsstufe zugeordnet wird.

Ein Übertragungsfehler an der Bitstelle, welche höchste binäre Wertigkeit hat (Most Significant Bit, MSB), führt damit zu sehr großen Unterschieden im decodierten und gesendeten Abtastwert, während ein Bitfehler an der niederwertigsten Bitstelle (Least Significant Bit, LSB) meist zu sehr geringen, oft vernachlässigbaren Abweichungen führt. Durch die Struktur der PCM-Codierung ist daher eine Gewichtung der codierten Daten bereits implizit vorhanden.

Mit Hilfe des Verfahrens nach der Erfindung kann diese implizite Prioritätsgewichtung der Daten ausgenutzt werden. Für eine bestimmte vorgegebene maximale Decodierverzögerung lassen sich durch Zusammenfassen mehrerer PCM-codierter Abtastwerte größere Blöcke bilden. Die Daten dieser zusammengefaßten Blöcke werden dann entsprechend der Gewichtung der einzelnen Bitstellen umgeordnet, so daß die MSBs am Blockanfang und dann die anderen Bits nach abfallender Wertigkeit zum Blockende hin angeordnet werden. Für diesen Block läßt sich dann ein abfallendes Ratenprofil, beispielsweise in Treppenform, entwerfen, das einen starken Schutz der MSBs und einen schwächeren Schutz der LSBs garantiert.

Für einen gegebenen Kanal garantiert diese Art der Codierung, daß bei einem guten Kanalzustand sämtliche Information korrekt decodiert werden kann. Für schlechtere Übertragungsbedingungen ist zumindest der korrekte Empfang der höherwertigen Bitstellen garantiert, was im Prinzip äquivalent ist zu einer Quantisierung mit einer geringeren Wortbreite.

Dies läßt sich beispielsweise durch den Einsatz eines sequentiellen Decodieralgorithmus in Verbindung mit einem Faltungscode hohen Gedächtnisses erreichen, der zusätzlich noch Information über den Ort des ersten Decodierfehlers liefern kann. Der Anwendungsdecoder der Anwendung, der die PCM-codierten Daten zugrunde liegen, kann diese Fehlerortsinformation gewinnbringend einsetzen.

PCM-Codierung wird sehr oft zur Übertragung von Meßsignalen eingesetzt. Dabei werden die Meßwerte quantisiert und nach dem vorstehend beschriebenen, bekannten Verfahren binär codiert und an Auswertungsstellen übertragen. Unter diesen Voraussetzungen ist das erfindungsgemäße Verfahren auch auf dem großen Gebiet der Meßsignalübertragungen anwendbar. Es lassen sich alle vorher erwähnten Methoden direkt übertragen, und es wird damit eine im Vergleich zu Standardverfahren bessere Übertragung ermöglicht, selbst wenn die PCM-codierten Meßsignale über sehr gestörte Kanäle übertragen werden müssen.

Das Verfahren nach der Erfindung läßt sich in vorteilhafter Weise auch bei der mobilen Audioübertragung verwenden. Als Beispiel, das sich in diese Kategorie einordnen läßt, soll im folgenden das Digital Audio Broadcasting (DAB)-System betrachtet werden. Ähnlich zu den bereits beschriebenen Anwendungsfällen bietet sich auch hier die Möglichkeit, durch Anwendung des erfindungsgemäßen Verfahrens eine Qualitätssteigerung zu erzielen.

Bei Anwendungen im Bereich des mobilen Audios sind prinzipiell dieselben Störmechanismen zu bekämpfen, die beispielsweise auch im GSM System zu Verfälschungen der übertragenen Information führen. Zum einen ist dabei die Abhängigkeit der Empfangsamplitude vom Standort des jeweiligen Empfängers zu nennen. In Abhängigkeit von der Entfernung zum Sender ergibt sich dabei beispielsweise eine bestimmte Freiraumdämpfung oder es entstehen auch Effekte durch Abschattungen im Funkausbreitungsweg. Zum anderen ergeben sich Störungen durch die Mobilität der jeweiligen Nutzer und durch andere Nutzer (Interferenzstörungen).

Die Störeffekte lassen sich in zwei Gruppen einteilen: Störungen, die durch die unterschiedlichen Aufenthaltsorte der Empfänger bedingt sind, und Störungen, die durch die zeitliche Mobilität der Empfänger hervorgerufen werden. Um mit Standardverfahren allen Empfängern eine Empfang zu ermöglichen, muß das Kanalcodiersystem für den Empfänger mit den schlechtesten Empfangsbedingungen entworfen werden. Das führt dazu, daß das System für Empfänger mit besseren Empfangsbedingungen bezüglich der Kanalcodierung (Redundanz) überdimensioniert ist.

Mit Hilfe des Verfahrens nach der Erfindung kann ein Kanalcodiersystem entworfen werden, das es Empfängern mit guten Empfangsbedingungen erlaubt, ein Maximum an Information zu decodieren, und das es gleichzeitig ermöglicht, die Decodierung einer Grundinformation auch für Empfänger mit ungünstigen Empfangsbedingungen sicherzustellen, ohne die Datenrate zugunsten dieser "schlechten" Empfänger zu sehr zu drücken.

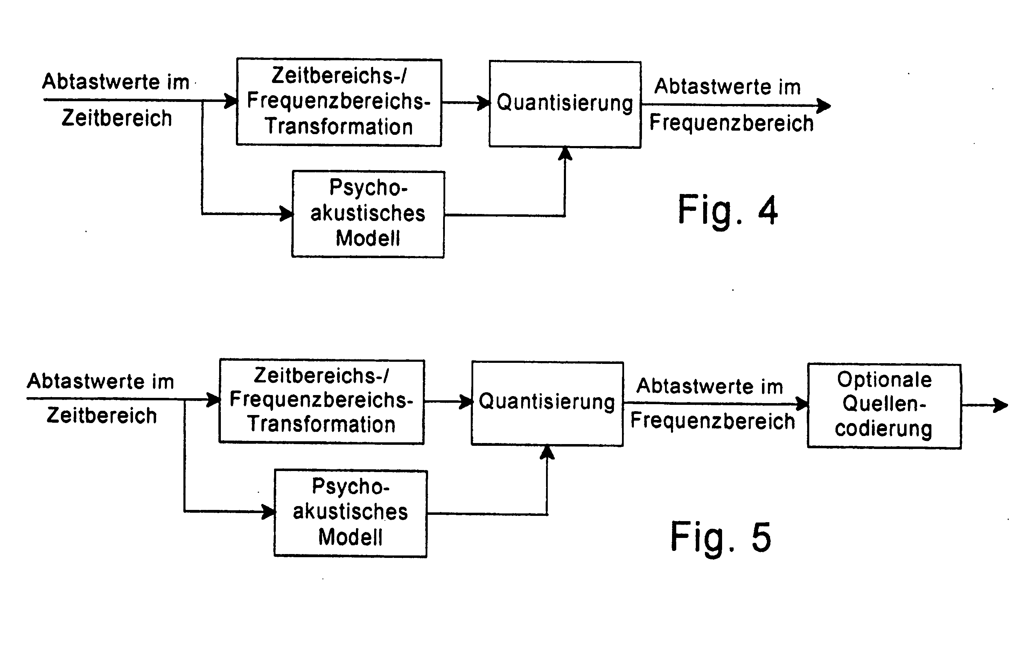

Fig. 4 zeigt die prinzipielle Vorgehensweise, um aus einem abgetasteten Audio-Zeitbereichssignal, basierend auf psychoakustischen Erwägungen, ein komprimiertes Datensignal zur Übertragung zu generieren. Dazu wird das abgetastete Zeitbereichssignal einer Zeit-/Frequenzbereichs-Transformation unterworfen, deren Abtastwerte auf der Grundlage psychoakustischer Überlegungen mit einer bestimmten Wortbreite quantisiert werden.

Analog zur PCM-Übertragung kann auch hier eine Ordnung des Bitstroms der Abtastwerte nach Wertigkeit erfolgen. Zusätzlich ist auch noch Sorge dafür zu tragen, daß bestimmte, für die Decodierung zwingend nötige Informationen im Bitstrom, wie beispielsweise Codebücher, Verstärkungfaktoren usw., sicher korrekt decodiert werden.

Diese Anforderung ist durch den Einsatz des Verfahrens nach der Erfindung erfüllbar. Es wird ein auf die speziellen Erfordernisse der Audio-Anwendungen angepaßtes Ratenprofil entworfen. Dazu werden wieder Blöcke gebildet, innerhalb welcher die zwingend notwendige Information zur Decodierung vorne im Block angeordnet wird, und der Rest des Blocks nach Wichtigkeit geordnet wird. Basierend auf dieser Anordnung wird ein Ratenprofil entworfen, dessen Rate vom Blockanfang zum Blockende abnimmt, wobei durch den Verlauf dieses Profils sichergestellt wird, daß die zwingend notwendige Information von allen Empfängern richtig decodiert werden kann.

Dabei wird in vorteilhafter Weise ein Faltungscode großen Gedächtnisses eingesetzt, der durch einen sequentiellen Algorithmus decodiert wird, der unter Umständen eine Lokalisierung des ersten Fehlers ermöglicht. Durch diese Lokalisierung des ersten Fehlers eröffnet sich die Möglichkeit, anhand von Qualitätsuntersuchungen zu entscheiden, ob die restlichen, nicht korrekt decodierten Bits gar nicht, mit den unter Umständen verfälschten, systematischen Bits des Datenstroms, mit Zufallsdaten oder mit Daten aus vorhergehenden Blöcken (Concealment) aufgefüllt werden sollen.

Auch hier kann die Empfangsqualität durch die Decodierkomplexität des sequentiellen Decoders sehr einfach und effektiv skaliert werden; beispielsweise kann bei ausreichend vorhandener Energie (beispielsweise des Akkus) die Decodierkomplexität des Decoders höher gesetzt werden, so daß der entsprechende Empfänger eine bessere Qualität decodieren kann. Die Gegebenheiten des Rundfunks (Broadcast) bieten sich für den Einsatz des Verfahrens nach der Erfindung geradezu an, da die Verzögerung, die sich beispielsweise durch Blockbildung ergibt, für den Empfang von Audio-Daten im Rundfunk keine Beeinträchtigung darstellt.

Für den Fall der Anwendung im Bereich des mobilen Audios läßt sich ähnlich wie bei den davor beschriebenen Anwendungsbeispielen auch eine weitere Steigerung der Effektivität des erfindungsgemäßen Verfahrens durch die Anpassung der entsprechenden Quellencodierverfahren erreichen, indem die Eigenschaften der neuen Schnittstelle bezüglich Fehlerlokalisierung besser ausgenutzt werden.

Das Verfahren nach der Erfindung läßt sich in vorteilhafter Weise auch beim sogenannten Audio Broadcast über das Internet verwenden. Audio Broadcast über Internet hat in letzter Zeit mit dem Beginn der Ausstrahlung von Radioprogrammen über das Internet stark an Bedeutung gewonnen. Ein Beispiel ist der Real Audio Player, der den Empfang zahlreicher Radio Programme über das Internet ermöglicht.

Ähnlich wie bereits vorstehend beim mobilen Audio beschrieben wurde, wird auch hier eine Kompression des Audiosignals durch die Anwendung generischer Sprachcodieralgorithmen erreicht. In Fig. 5 ist die prinzipielle Vorgehensweise dargestellt. Das abgetastete Audio-Zeitbereichssignal wird einer Zeit/Frequenzbereichs-Transformation unterzogen, und die Quantisierung der im Frequenzbereich erhaltenen Abtastwerte wird wieder anhand psychoakustischer Erwägungen gesteuert.

Um eine weitere Kompression zu erzielen, wird dann ein weiteres Codierverfahren angeschlossen, beispielsweise in Form einer Entropiecodierung wie der Huffman-Codierung, womit eine weitere Kompression erreicht werden kann. Die verwendete Codierung ist aber oft sehr anfällig gegen Fehlerfortpflanzung, so daß Decodierfehler meist dazu führen, daß die restlichen Daten unbrauchbar werden bzw. zu sehr stark verminderter Qualität aufgrund von Fehlinterpretationen führen. Auch hier kann das erfindungsgemäße Verfahren in vorteilhafter Weise eingesetzt werden, da eine Fehlerlokalisierung helfen kann, die erwähnten Effekte zu vermeiden.

Der "Internetkanal" unterscheidet sich insofern deutlich von den oben erwähnten Mobilfunkkanälen bzw. von der Luftschnittstelle, als die Datenübertragung meist über sehr sichere Übertragungsmedien erfolgt, wie beispielsweise Glasfaserleitungen, so daß die Übertragung an sich nahezu fehlerfrei erfolgt. Begrenzt wird das System also nicht durch das Auftreten von Bitfehlern, sondern durch die sogenannte Paketverlustwahrscheinlichkeit. Paketverluste treten immer dann auf, wenn die Summe der von den Anwendungen angeforderten Übertragungsrate die Netzkapazität übersteigt, und infolgedessen die vom System zur Verfügung gestellten Zwischenspeicher überlaufen (Puffer-Überlauf) bzw. die maximal tolierbare Verzögerung überschritten wird.

Analog zur Videoübertragung über ATM kann auch beim Internet von statistischem Multiplexing gesprochen werden. Viele Anwendungen teilen sich das physikalische Übertragungsmedium und die vorhandene Datenrate wird für alle Anwendungen verwendet. Ist keine Kapazität mehr vorhanden, so kommt es zu Blockierungen. Dies hat zur Folge, daß die zu übertragenden Daten auf anderen Routen übertragen und gepuffert werden müssen.

In diesem Szenario kann es auf zweierlei Weise zu Paketverlusten kommen. Zum einen können Puffer überlaufen und damit die Daten einfach verloren gehen, zum anderen hat jede Anwendung eine maximale Verzögerungszeit. Wird diese Zeit überschritten, so wird mit der Decodierung der bereits empfangenen Daten begonnen. Nach dieser Zeit ankommende Pakete können nicht mehr berücksichtigt werden und müssen daher wie verlorene Pakete behandelt werden.

Durch vorteilhafte Anwendung des Verfahrens nach der Erfindung können diese Paketverluste folgendermaßen behandelt werden: Durch ein geeignet entworfenes Interleaving-Verfahren werden die Paketverluste in statistisch unabhängige "Einzel"-Auslöschungen (erasures) umgewandelt. Eine Auslöschung bedeutet, daß dem Anwendungsdecoder bekannt ist, daß an dieser Stelle ein Datenbit fehlt; es ist jedoch nicht bekannt, welcher Wert an dieser Bitstelle übertragen wurde. Das Interleaving bewirkt also, zumindest ansatzweise, die Umwandlung des Internetkanals mit Paketverlusten in einen sogenannten binären Auslöschungskanal (Binary Erasure Channel).

Durch den vorteilhaften Einsatz eines vom Blockanfang zum Blockende abfallenden Ratenprofils kann dann ein gewichteter Fehlerschutz erreicht werden, wobei wieder ein Faltungscode großen Gedächtnisses in Verbindung mit sequentieller Decodierung angewendet werden kann, der eine Lokalisierung des ersten Decodierfehlers im Block ermöglicht. Diese Information ist insofern sehr wichtig, da es bei den in Fig. 5 mit optionaler Quellencodierung bezeichneten Verfahren oft zu einer Fehlerfortpflanzung kommt, die zu gravierenden Qualitätseinbußen im decodierten Signal führt.

**Patentansprüche**

1. Verfahren zur Übertragung quellencodierter digitaler Signale, denen bitweise, symbolweise oder in Gruppen unterschiedliche Wichtigkeiten zuordenbar sind, in Datenrahmen über einen Kanal, wobei bei der auf der Sendeseite vor einer Kanalcodierung erfolgenden Quellencodierung pro Datenrahmen eine Aufteilung einer Gesamtinformation in beliebig viele verschieden wichtige Informationsteileinheiten, also in sogenannte Hierarchieklassen, bitweise, symbolweise oder in Gruppen vorgenommen wird bei dem der quellencodierte Datenstrom durch einen einzigen, gleichzeitig Fehlererkennung/-lokalisierung und Fehlerkorrektur ermöglichenden Code kanalcodiert wird, bei dem auf der Empfangsseite eine Kanaldecodierung verwendet wird, die geeignet ist für jeden empfangenen Datenrahmen eine von der momentanen Qualität des Kanals und/oder der bereitgestellten Decodierkomplexität und/oder der verfügbaren Empfängerkomplexität abhängige Teilmenge der übertragenen Informationsteileinheiten korrekt zu decodieren wobei der korrekte Anteil der decodierten Daten aus den Eigenschaften des Decodierverfahrens bestimmt wird, und daß zur Rekonstruktion des Quellensignals nur die als korrekt decodierte Teilmenge der übertragenen Informationsteileinheiten verwendet und zur Anwendung weitergegeben wird.

2. Verfahren nach Anspruch 1, **dadurch gekennzeichnet, daß** die für die jeweilige Anwendung wichtigsten Informationsteileinheiten zuerst und danach der Reihe nach abfallender Wichtigkeit die unwichtigeren Informationsteileinheiten zuletzt in den zu übertragenden Datenrahmen codiert angeordnet werden.

3. Verfahren nach Anspruch 1 oder 2, **dadurch gekennzeichnet, daß** für die Quellencodierung variable Längencodes verwendet werden.

4. Verfahren nach einem der vorhergehenden Ansprüche, **dadurch gekennzeichnet, daß** bei Abhängigkeit der Interpretation einer Informationsteileinheit von der Korrektheit einer anderen In - formationsteileinheit die abhängige Informationsteileinheit weiter in Richtung zum Datenrahmenende hin codiert angeordnet wird.

5. Verfahren nach einem der vorhergehenden Ansprüche, **gekennzeichnet durch** die Verwendung von Codes mit variabler Redundanz, so daß die Coderate über die Datenrahmenlänge bis auf einen Maximalwert, der kleiner oder gleich eins ist, ansteigt.

6. Verfahren nach einem der Ansprüche 1 bis 4, **gekennzeichnet durch** die Verwendung von ratenkompatiblen Codes, deren Rate über die Datenrahmenlänge bis auf einen Maximalwert, der kleiner oder gleich eins ist, ansteigt.

7. Verfahren nach Anspruch 1, **dadurch gekennzeichnet, daß** die Informationsteileinheiten geordnet nach Wichtigkeit sowohl vom Datenrahmenanfang als auch vom Datenrahmenende her mit zur Datenrahmenmitte von beiden Seiten abfallender Wichtigkeit angeordnet werden.

8. Verfahren nach Anspruch 7, **gekennzeichnet durch** die Verwendung von sowohl präfix- als auch suffixfreien, variablen Längencodes zur Quellencodierung.

9. Verfahren nach Anspruch 7, **gekennzeichnet durch** die Verwendung im fehlerrobusten Modus der MPEG-4-Videocodierung auf den mit reversiblen variablen Längencodes codierten Teil.

10. Verfahren nach Anspruch 7, **dadurch gekennzeichnet, daß** bei Abhängigkeit einer Informationsteileinheit von der Korrektheit einer anderen Informationsteileinheit die abhängige Informationsteileinheit weiter in Richtung zur Datenrahmenmitte hin codiert angeordnet wird.

11. Verfahren nach Anspruch 7, 8 oder 10, **gekennzeichnet durch** die Verwendung von Codes mit variabler Redundanz, deren Coderate vom Datenrahmenanfang und -ende zur Datenrahmenmitte bis auf einen Maximalwert, der kleiner oder gleich eins ist, ansteigt und die gleichzeitig oder hintereinander vom Datenrahmenanfang und -ende decodiert werden können.

12. Verfahren nach einem der Ansprüche 7, 8, 10 oder 11, **gekennzeichnet durch** die Verwendung von ratenkompatiblen Codes, deren Coderate vom Datenrahmenanfang und -ende zur Datenrahmenmitte bis auf einen Maximalwert, der kleiner oder gleich eins ist, ansteigt und die gleichzeitig oder hintereinander vom Datenrahmenanfang und -ende decodiert werden können

13. Verfahren nach einem der vorhergehenden Ansprüche, **gekennzeichnet durch** eine Decodierung **durch** sequentielle Decodieralgorithmen (Stack-Algorithmus, Fano-Algorithmus).

14. Verfahren nach einem der vorhergehenden Ansprüche, **dadurch gekennzeichnet, daß** die fehlerfreie Decodierung eines Teils der Information durch entsprechende Verfahren lokalisiert wird.

15. Verfahren nach einem der vorhergehenden Ansprüche, **dadurch gekennzeichnet, daß** eine adaptive, sequentielle Decodierung mit gegebener Komplexität kombiniert mit einem Faltungscode von hohem Gedächtnis und variabler Rate verwendet wird, die, bedingt durch die für die Decodierung benötigte Komplexität und den Kanalzustand, nur bis zu einer bestimmten Datenrahmentiefe decodiert, und dass das ursprüngliche digitale Sendesignal dann aus diesen, fehlerfreien angenommenen Daten rekonstruiert wird.

16. Verfahren nach Anspruch 14 oder 15, **dadurch gekennzeichnet, daß** der fehlerfrei decodierte Teil der Information anhand der Stoppstelle des Decoders oder der Metrik oder der verbrauchten Decoderressource oder ihrer Änderung oder anderer geeigneter Informationen aus dem sequentiellen Decodiervorgang oder einer Kombination aus den vorgenannten Kriterien lokalisiert wird.

17. Verfahren nach einem der Ansprüche 14 bis 16, **dadurch gekennzeichnet, daß** zur Decodierung ein mit dem Stack-Algorithmus arbeitender Decoder verwendet wird und die Lokalisierung des ersten Fehlers anhand des Stack-Inhalts erfolgt.

18. Verfahren nach Anspruch 17, **dadurch gekennzeichnet, daß** aus dem Stack-Inhalt eine Zuverlässigkeitsinformation über jede einzelne decodierte Informationsteileinheit generiert wird.

19. Verfahren nach Anspruch 14, **dadurch gekennzeichnet, daß** aus den Eigenschaften des sequentiellen Decodierprozesses eine Zuverlässigkeitsinformation über jeden Teilpfad des decodierten Pfads generiert wird.

20. Verfahren nach den Ansprüchen 16 bis 19, **dadurch gekennzeichnet, daß** die Fehlerlokalisierung durch eine geeignete Kombination von zwei oder mehr der genannten Kriterien erfolgt.

21. Verfahren nach einem der vorhergehenden Ansprüche, **gekennzeichnet durch** die Anwendung von quellengesteuerter Kanalcodierung, Kanaldecodierung und iterativer Decodierung.

22. Verfahren nach einem der vorhergehenden Ansprüche, **dadurch gekennzeichnet, daß** ein Kanal mit Paketverlusten durch ein entsprechendes Interleaving in einen Auslöschungskanal umgewandelt wird.

23. Verfahren nach einem der vorhergehenden Ansprüche, **gekennzeichnet durch** die Verwendung bei der Übertragung von digitalen Sprach-, Text-, Ton-, Bild-, Video- oder Meßsignalen oder von daraus kombinierten Signalen, insbesondere Multimediadaten.

24. Verfahren nach Anspruch 23, **gekennzeichnet durch** die Verwendung bei der Übertragung JPEG (Joint Photographic Experts Group; Standard für Stillbildkompression)-codierter Standbilder.

25. Verfahren nach Anspruch 23, **gekennzeichnet durch** die Verwendung bei der Sprachübertragung über GSM (Global System for Mobile Communication) .

26. Verfahren nach Anspruch 23, **gekennzeichnet durch** die Verwendung bei der Videoübertragung über ATM (Asynchroner Transfer-Modus).

27. Verfahren nach Anspruch 23, **gekennzeichnet durch** die Verwendung beim Internet-Paketübertragungsprotokoll (IP), wobei nicht oder verspätet ankommende Pakete **durch** die Verwendung eines entsprechenden Interleaving-Verfahrens in Auslöschungen umgewandelt werden.

28. Verfahren nach Anspruch 23, **gekennzeichnet durch** die Verwendung beim Fernsehrundfunk.

29. Verfahren nach Anspruch 23, **gekennzeichnet durch** die Verwendung bei der PCM-Übertragung von Daten, insbesondere von Meßsignalen.

30. Verfahren nach Anspruch 23, **gekennzeichnet durch** die Verwendung bei mobiler Audioübertragung, insbesondere bei dem DAB(Digital Audio Broadcasting)-System.

31. Verfahren nach Anspruch 23, **gekennzeichnet durch** die Verwendung bei Audio-Broadcast über das Internet, wobei nicht oder verspätet ankommende Pakete mittels eines entsprechenden Interleaving-Verfahrens gelöscht werden.

32. Verfahren nach einem der Ansprüche 1 bis 24 oder 28, **dadurch gekennzeichnet, daß** die Übertragung der quellencodierten digitalen Signale durch eine Speicherung dieser Signale realisiert wird, wobei das jeweilige Speichermedium, beispielsweise ein magnetisches Aufzeichnungsmedium, den Kanal bildet.

33. Empfänger zum Empfang quellencodierter digitaler Signale, denen bitweise, symbolweise oder in Gruppen unterschiedliche Wichtigkeiten zuordenbar sind, mit Mitteln zum Empfang von Datenrahmen über einen Kanal, wobei pro Datenrahmen bei der auf der Sendeseite vor einer Kanalcodierung erfolgten Quellencodierung eine Aufteilung einer Gesamtinformation in beliebig viele verschieden wichtige Informationsteileinheiten, also in sogenannte Hierarchieklassen, bitweise, symbolweise oder in Gruppen vorgenommen ist, bei dem der quellencodierte Datenstrom durch einen einzigen, gleichzeitig Fehlererkennung/-lokalisierung und Fehlerkorrektur ermöglichenden Code kanalcodiert ist, mit Mitteln für eine Kanaldecodierung derart kodierter Datenrahmen, die geeignet sind für jeden empfangenen Datenrahmen eine von der momentanen Qualität des Kanals und/oder der bereitgestellten Decodierkomplexität und/oder der verfügbaren Empfängerkomplexität abhängige Teilmenge der übertragenen Informationsteileinheiten korrekt zu decodieren, wobei der korrekte Anteil der decodierten Daten aus den Eigenschaften des Decodierverfahrens bestimmt wird, und mit Mitteln zur Rekonstruktion des Quellensignals, die derart ausgestaltet sind, dass nur die als korrekt decodierte Teilmenge der übertragenen Informationsteileinheiten verwendet und zur Anwendung weitergegeben wird.

34. Empfänger nach Anspruch 33, **dadurch gekennzeichnet, daß** der Empfänger dazu eingerichtet ist, die fehlerfreie Decodierung eines Teils der Information durch entsprechende Verfahren zu lokalisieren.

35. Empfänger nach einem der Ansprüche 33 oder 34, **dadurch gekennzeichnet, dass** er Mittel für eine adaptive, sequentielle Decodierung mit gegebener Komplexität kombiniert mit Mitteln zur Dekodierung eines Faltungscodes von hohem Gedächtnis und variabler Rate die, bedingt durch die für die Decodierung benötigte Komplexität und den Kanalzustand, nur bis zu einer bestimmten Datenrahmentiefe decodiert, und dass das ursprüngliche digitale Sendesignal dann aus diesen, fehlerfrei angenommenen Daten rekonstruiert wird.

36. Empfänger nach Anspruch 33, 34 oder 35, derart ausgestaltet daß der fehlerfrei decodierte Teil der Information anhand der Stoppstelle des Decoders oder der Metrik oder der verbrauchten Decoderressource oder ihrer Änderung oder anderer geeigneter Informationen aus dem sequentiellen Decodiervorgang oder einer Kombination aus den vorgenannten Kriterien lokalisiert wird.

37. Empfänger nach einem der Ansprüche 33 bis 36, derart ausgestaltet, daß der Empfänger zur Decodierung ein mit dem Stack-Algorithmus arbeitenden Decoder verwendet und die Lokalisierung des ersten Fehlers anhand des Stack-Inhalts erfolgt.

38. Empfänger nach Anspruch 37, derart ausgestaltet, daß aus dem Stack-Inhalt eine Zuverlässigkeitsinformation über jede einzelne decodierte Informationsteileinheit generiert wird.

39. Empfänger nach Anspruch 33, derart ausgestaltet, daß aus den Eigenschaften des sequentiellen Decodierprozesses eine Zuverlässigkeitsinformation über jeden Teilpfad des decodierten Pfads generiert wird.

40. Empfänger nach den Ansprüchen 33 bis 39, derart ausgestaltet, daß die Fehlerlokalisierung durch eine geeignete Kombination von zwei oder mehr der genannten Kriterien erfolgt.

**Claims**

1. A method for transmission of source encoded digital signals to which different levels of significance may be assigned by bits, by symbols or in groups, in data frames via one channel, in which in the source encoding which takes place at the transmitting end before channel encoding there is a division for each data frame of an overall unit of information into any desired number of information subunits of differing levels of significance, in other words into so-called hierarchical classes, by bits, by symbols or in groups , wherein the source encoded data stream is channel encoded by means of a single code which simultaneously allows both for error detection and location and for error correction, wherein on the receiving end a channel decoding is used that is adapted to decode correctly for each received data frame a subset of the information subunits transmitted , with this subset being dependent upon the quality of the channel at that moment and/or the decoding complexity provided and/or the receiver complexity available, and that the correct portion of the decoded data can be determined from the characteristics of the decoding method, and that only the as correctly decoded recognised subset of the information subunits transmitted is used for reconstruction of the source signal and passed on to the application.

2. A method in accordance with Claim 1, **characterised in that** in the data frame which is to be transmitted, the information subunits which are most significant for the application concerned are arranged first and after that the less significant information subunits are arranged in sequence according to their decreasing significance in encoded form.

3. A method in accordance with Claim I or 2, **characterised in that** for the source encoding, variable length codes are used.

4. A method in accordance with one of the preceding claims, **characterised in that** where the interpretation of one information subunit is dependent on the correctness of another information subunit, the dependent subunit is arranged in encoded form further towards the end of the data frame.

5. A method in accordance with one of the preceding claims, **characterised by** the use of codes of variable redundancy, such that the code rate increases along the length of the data frame up to a maximum that is equal to or less than unity.

6. A method in accordance with one of Claims 1 to 4, **characterised by** the use of rate-compatible codes, the rate of which increases along the length of the data frame up to a maximum that is equal to or less than unity.

7. A method in accordance with Claim 1, **characterised in that** the information subunits are arranged in order of decreasing significance both from the start and from the end of the data frame towards the middle of the data frame

8. A method in accordance with Claim 7, **characterised by** the use of both prefix-free and suffix-free variable length codes for the source encoding.

9. A method in accordance with Claim 7, **characterised by** the use in the robustly error-resistant mode of MPEG-4 video coding on the portion encoded with reversible variable length codes.

10. A method in accordance with Claim 7, **characterised in that** where the interpretation of one information subunit is dependent on the correctness of another information subunit, the dependent subunit is arranged in encoded form further towards the middle of the data frame.

11. A method in accordance with Claim 7, 8 or 10, **characterised by** the use of codes of variable redundancy, the code rate of which increases from the start and end of the data frame towards the middle of the data frame up to a maximum that is equal to or less than unity and which can be decoded simultaneously or sequentially from the start and end of the data frame.

12. A method in accordance with one of the Claims 7, 8 10 or 11, **characterised by** the use of rate-compatible codes, the code rate of which increases from the start and end of the data frame towards the middle of the data frame up to a maximum that is equal to or less than unity and which can be decoded simultaneously or sequentially from the start and end of the data frame.

13. A method in accordance with one of the preceding claims, **characterised by** a decoding by means of sequential decoding algorithms (stack algorithm, Fano algorithm).

14. A method in accordance with one of the preceding claims, **characterised in that** the flawless decoding of a part of the information is located by appropriate methods.

15. A method in accordance with one of the preceding claims, **characterised in that** ar adaptive sequential decoding of a given complexity combined with a convolutional code with large memory and variable rate is used which, as a function of the complexity needed for decoding and the channel condition, decodes only as far as a certain data frame depth and that the original digital transmission signal is then reconstructed from these data assumed to be flawless.

16. A method in accordance with Claim 14 or 15, **characterised in that** the flawless decoded portion of the information is located from the point where the decoder stopped or by metrics or by the consumed decoding resource or by a change in it or in other appropriate information from the sequential decoding process or by a combination of the criteria just listed.

17. A method in accordance with one of the Claims 14 to 16, **characterised in that** for decoding a decoder working with the stack algorithm is used and the location of the first error is performed using the content of the stack.

18. A method in accordance with Claim 17, **characterised in that** reliability information on every individual decoded information subunit is generated from the content of the stack.

19. A method in accordance with Claim 14, **characterised in that** reliability information on every sub-path of the decoded path is generated from the characteristics of the sequential decoding process.

20. A method in accordance with Claims 16 to 19, **characterised in that** the error location is performed by means of a suitable combination of two or more of the criteria listed.

21. A method in accordance with one of the preceding claims, **characterised by** the use of source-controlled channel encoding, channel decoding and iterative decoding.

22. A method in accordance with one of the preceding claims, **characterised in that** a channel with packet losses is converted by means of an appropriate interleaving process into an erasure channel

23. A method in accordance with one of the preceding claims, **characterised by** use in transmission of digital speech, text, sound, image, video or measurement signals or of signals combined from them, in particular multimedia data.

24. A method in accordance with Claim 23, **characterised by** use in transmission of JPEG-encoded still images (Joint Photographic Experts Group; Standard for Compression of Still Images).

25. A method in accordance with Claim 23, **characterised by** use in speech transmission via GSM (Global System for Mobile Communication).

26. A method in accordance with Claim 23, **characterised by** use in video transmission via ATM (Asynchronous Transfer Mode).

27. A method in accordance with Claim 23, **characterised by** use in the Internet packet transmission protocol (IP), with packets which arrive late or do not arrive being converted by use of an appropriate interleaving process into erasures.

28. A method in accordance with Claim 23, **characterised by** use in television broadcasting.

29. A method in accordance with Claim 23, **characterised by** use in PCM transmission of data, in particular measurement signals.

30. A method in accordance with Claim 23, **characterised by** use in mobile audio transmission, in particular with the DAB (Digital Audio Broadcasting) system.

31. A method in accordance with Claim 23, **characterised by** use in audio broadcasting via the Internet, in which packets which arrive late or do not arrive are erased by means of an appropriate interleaving process.

32. A method in accordance with one of Claims 1 to 24 or 28, **characterised in that** the transmission of the source encoded digital signals is implemented by means of a storage of these signals, with the storage medium involved, for example a magnetic recording medium, constituting the channel.

33. A receiver for receiving source encoded digital signals to which different levels of significance may be assigned by bits, by symbols or in groups,
with means for receiving data frames via one channel, wherein for each data frame in the source encoding which took place at the transmitting end before channel encoding there is a division of an overall unit of information into any desired number of information subunits of differing levels of significance, in other words into so-called hierarchical classes, by bits, by symbols or in groups, wherein the source encoded data stream is channel encoded by means of a single code which simultaneously allows both for error detection and location and for error correction, and with means for channel decoding that are adapted to decode correctly for each received data frame a subset of the information subunits transmitted, with this subset being dependent upon the quality of the channel at that moment and/or the decoding complexity provided and/or the receiver complexity available, wherein the correct portion of the decoded data is determined from the characteristics of the decoding method, and with means for reconstructing the source signal which are adapted to use and pass on to the application only the as correctly decoded recognised subset of the transmitted information subunits.

34. A receiver in accordance with claim 33, adapted to locating the flawless decoding of a part of the information by appropriate methods.

35. A receiver in accordance with claim 33 or 34, **characterized in that** it comprises means for an adaptive sequential decoding of a given complexity combined with a convolutional code with a large memory and variable rate, which as a function of the complexity needed for decoding and the channel condition, decodes only as far as a certain data frame depth and that the original digital transmission signal is then reconstructed from these data assumed to be flawless.

36. A receiver in accordance with Claim 33, 34 or 35, adapted to locatethe flawless decoded portion of the information from the point where the decoder stopped or by metrics or by the consumed decoding resource or by a change in it or in other appropriate information from the sequential decoding process or by a combination of the criteria just listed.

37. A receiver in accordance with one of the Claims 33 to 36, wherein for decoding a decoder is adapted to work with the stack algorithm is used and wherein the receiver is adapted to locate of the first error by using the content of the stack.

38. A receiver in accordance with Claim 37, adapted to generate reliability information on every individual decoded information subunit from the content of the stack.

39. A receiver in accordance with Claim 33, adapted to generate reliability information on every sub-path of the decoded path from the characteristics of the sequential decoding process.

40. A receiver in accordance with Claims 33 to 39, adapted to perform the error location by means of a suitable combination of two or more of the criteria listed.

**Revendications**

1. Méthode de transmission de signaux numériques codés à la source auxquels des niveaux différents d'importance peuvent être attribués par des bits, par des symboles ou en groupes, dans des cadres de données, via un canal, dans laquelle dans le codage à la source qui a lieu l'extrémité de transmission avant le codage du canal, il y a une division pour chaque cadre de données d'une unité globale d'information en n'importe quel nombre voulu de sous-unités d'informations de niveaux d'importance différents, en d'autres termes en classes dites hiérarchiques, par bits, par symboles ou en groupes, dans laquelle le flux de données codées à la source est codé par canal au moyen d'un code unique qui permet simultanément à la fois la détection et l'emplacement d'erreurs, et la correction d'erreurs, dans laquelle à l'extrémité réceptrice, on utilise un décodage de canal qui est adapté pour décoder correctement pour chaque cadre de données reçu un sous-ensemble des sous-unités d'informations transmises, ce sous-ensemble étant indépendant de la qualité du canal à ce moment et/ou la complexité de décodage prévue et/ou la complexité du récepteur disponible, et que la portion correcte des données décodées peut être déterminée à partir des caractéristiques de la méthode de décodage, et que seul le sous-ensemble reconnu comme correctement décodé des sous-unités d'informations est utilisé pour la reconstruction du signal source et passé à l'application.

2. Méthode selon la revendication 1, **caractérisée en ce que** dans le cadre de données qui doit être transmis, les sous-unités d'informations qui sont les plus importantes pour l'application concernée sont disposées en premier et après que les sous-unités d'informations moins importantes sont disposées à la suite en fonction de leur importance décroissante sous forme codée.

**3.** Méthode selon la revendication 1 ou 2, **caractérisée en ce que** pour le codage à la source, on utilise des codes de longueur variable.

**4.** Méthode selon l'une des revendications qui précèdent, **caractérisée en ce que** si l'interprétation d'une sous-unité d'informations dépend de l'exactitude d'une autre sous-unité d'informations, la sous-unité dépendante est disposée sous forme codée plus vers l'extrémité du cadre de données.

**5.** Méthode selon l'une des revendications qui précèdent, **caractérisée par** l'usage de codes de redondance variable, de façon que la fréquence de codes augmente sur la longueur du cadre de données jusqu'à un maximum qui est égal ou inférieur à l'unité.

**6.** Méthode selon l'une des revendications 1 à 4, **caractérisée par** l'usage de codes à vitesse compatibles, dont la vitesse accroît la longueur du cadre de données jusqu'à un maximum qui est égal ou inférieur à l'unité.

**7.** Méthode selon la revendication 1, **caractérisée en ce que** les sous-unités d'informations sont disposées de façon à diminuer l'importance à la fois à partir du commencement et de l'extrémité du cadre de données vers le milieu du cadre de données.

**8.** Méthode selon la revendication 7, **caractérisée par** l'usage de codes de longueur variable à la fois sans préfixe et sans suffixe pour le codage à la source.

**9.** Méthode selon la revendication 7, **caractérisée par** l'usage de codage vidéo MPEG-4 en mode robustement résistant aux erreurs sur la portion codée avec des codes de longueur variable réversibles.

**10.** Méthode selon la revendication 7, **caractérisée en ce que** si l'interprétation d'une sous-unité d'informations dépend de l'exactitude d'une autre sous-unité d'informations, la sous-unité d'informations étant disposée sous forme codée plus vers le milieu du cadre de données.

**11.** Méthode selon la revendication 14 ou 15, **caractérisée en ce que** la portion décodée sans défauts de l'information est située à partir du point du point où le décodeur a stoppé ou par métrique ou par la ressource de décodage consommée ou par un changement dans celui-ci ou dans une autre information appropriée à partir du processus de décodage séquentiel ou par une combinaison des critères qui viennent d'être listés.

**12.** Méthode selon la revendication 7, 8 ou 10, **caractérisée par** l'usage de codes de redondance variable, dont la vitesse de codes s'accroît à partir du début jusqu'à l'extrémité du cadre de données vers le milieu du cadre de données jusqu'à un maximum qui est égal ou inférieur à l'unité et qui peut être décodé simultanément ou séquentiellement à partir du début et de l'extrémité du cadre de données.

**13.** Méthode selon l'une des revendications précédentes, **caractérisée par** un décodage au moyen d'algorithmes de décodage séquentiels (algorithme d'empilement, algorithme de Fahno).

**14.** Méthode selon l'une des revendications précédentes, **caractérisée en ce que** le décodage sans défauts d'une partie de l'information est localisé par des méthodes appropriées.

**15.** Méthode selon l'une des revendication précédentes, **caractérisée en ce qu'**un décodage séquentiel adaptatif d'une complexité donnée combinée à un code convolutionnel à mémoire étendue et vitesse variable est utilisé, lequel, en fonction de la complexité nécessitée pour le décodage et la condition de canal, ne décode que dans la mesure où une certaine profondeur du cadre de données et où le signal de transmission numérique est ensuite reconstruit à partir de ces données considérées comme étant sans défauts.

**16.** Méthode selon la revendication 14 ou 15, **caractérisée en ce que** la portion sans défauts décodée de l'information est localisée à partir du point où le décodeur s'est arrêté ou par métrique ou par la ressource de décodage consommée ou par un changement de celui-ci ou par d'autres, informations appropriées venues du processus de décodage séquentiel ou par une combinaison des critères qui viennent d'être listés.

**17.** Méthode selon l'une des revendications 14 à 16, **caractérisée en ce que** pour le décodage, on utilise un décodeur fonctionnant avec l'algorithme d'empilement et **en ce que** la localisation de la première erreur est effectuée en utilisant le contenu de l'empilement.

18. Méthode selon la revendication 17, **caractérisée en ce que** des informations fiables sur chaque sous-unité d'information individuelle décodée est générée à partir du contenu du sac.

19. Méthode selon la revendication 14, **caractérisée en ce que** des informations fiables sur chaque sous-chemin du chemin décodé sont générées à partir des caractéristiques du processus de décodage séquentiel.

20. Méthode selon les revendications 16 à 19, **caractérisée en ce que** la localisation de l'erreur est effectuée au moyen d'une combinaison adéquate de deux ou plus des critères listés.

21. Méthode selon l'une des revendications précédentes, **caractérisée par** l'usage d'un codage de canal contrôlé à la source, décodage de canal et décodage itératif.

22. Méthode selon l'une des revendications précédentes, **caractérisée en ce qu'**un canal avec pertes par paquets est converti au moyen d'un processus d'imbrication approprié dans un canal d'effacement.

23. Méthode selon l'une des revendications précédentes, **caractérisée par** l'usage, dans la transmission, de discours numérique, texte, son, image, vidéo ou signaux de mesure ou de signaux combinés à partir de ceux-ci, en particulier données multimédia.

24. Méthode selon la revendication 23, **caractérisée par** l'usage, dans la transmission, d'images immobiles codées JPEG (Joint Photographic Experts Group ; Standard for Compression of Still Images).

25. Méthode selon la revendication 23, **caractérisée par** l'usage, dans la transmission vocale, via GSM (Global System for Mobile Communication).

26. Méthode selon la revendication 23, **caractérisée par** l'usage, dans la transmission vidéo via ATM (Asynchronous Transfer Mode).

27. Méthode selon la revendication 23, **caractérisée par** l'usage dans le protocole Internet (IP) de transmission par paquets, avec des paquets qui arrivent tard ou n'arrivent pas sont convertis par l'usage d'un processus d'imbrication approprié en effacements.

28. Méthode selon la revendication 23, **caractérisée par** l'usage dans la diffusion télévisée.

29. Méthode selon la revendication 23, **caractérisée par** l'usage dans la transmission PCM de données, dans des signaux de mesure appropriés.

30. Méthode selon la revendication 23, **caractérisée par** l'usage, dans la transmission audio mobile, en particulier avec le système DAB (Digital Audio Broadcasting).

31. Méthode selon la revendication 23, **caractérisée par** l'usage, dans la transmission audio via l'Internet, dans laquelle des paquets qui arrivent tard ou n'arrivent pas sont effacés au moyen d'un processus d'imbrication approprié.

32. Méthode selon l'une des revendications 1 à 24 ou 28, **caractérisée en ce que** la transmission des signaux numériques codés à la source est mise en oeuvre au moyen d'un enregistrement de ces signaux, le moyen d'enregistrement impliqué, par exemple un support d'enregistrement magnétique, constituant le canal.

33. Récepteur destiné à la réception de signaux numériques codés à la source auxquels des niveaux différents d'importance peuvent être attribués par des bits, par des symboles ou en groupes, dans des cadres de données, comportant des moyens de réception de cadres de données via un canal, dans lequel dans le codage à la source par cadre de données qui a lieu à l'extrémité de transmission avant le codage du canal, il y a une division pour chaque cadre de données d'une unité globale d'information en n'importe quel nombre voulu de sous-unités d'informations de niveaux d'importance différents, en d'autres termes en classes dites hiérarchiques, par bits, par symboles ou en groupes, dans lequel le flux de données codées à la source est codé par canal au moyen d'un code unique qui permet à la fois la détection et la localisation d'erreurs, et correction d'erreurs, dans laquelle à l'extrémité réceptrice, comportant des moyens de décodage de canal qui sont adaptés pour décoder correctement pour chaque cadre de données reçu un sous-ensemble des sous-unités d'informations transmises, ce sous-ensemble étant dépendant de la qualité du canal à ce moment et/ou la complexité de décodage prévue et/ou la complexité du récepteur disponible, moyennant quoi la portion correcte des données décodées à partir des caractéristiques de la méthode de décodage est déterminée, comportant des moyens pour reconstruire le signal source, qui sont conçus de telle sorte que uniquement le sous-ensemble reconnu comme correctement décodé des sous-unités d'informations est utilisé et passé à l'application.

**34.** Récepteur selon la revendication 33, adapté pour localiser le décodage sans défauts d'une partie de l'information par des méthodes adéquates.

**35.** Récepteur selon une des revendications 33 ou 34, **caractérisé en ce qu'**il présente un moyen de décodage séquentiel adaptatif d'une complexité donnée avec un code convolutionnel disposant d'une mémoire étendue et d'une vitesse variable, en fonction de la complexité nécessitée pour décoder et de la condition du canal, ne décode que dans la mesure où une certaine profondeur de cadre de données et que le signal de transmission numérique original est reconstruit ensuite à partir de ces données considérées comme étant sans défauts.

**36.** Récepteur selon la revendication 33, 34 ou 35, adapté pour localiser la portion sans défauts décodée de l'information à partir du point où le décodeur s'est arrêté ou par métrique ou par la ressource de décodage consommée ou par un changement dans celle-ci ou dans d'autres informations appropriées venues du processus de décodage séquentiel ou par une combinaison des critères qui viennent d'être listés.

**37.** Récepteur selon l'une des revendications 33 à 36, dans lequel, pour le décodage, on utilise un décodeur adapté pour fonctionner avec l'algorithme d'empilement et dans lequel le récepteur est adapté pour localiser la première erreur en utilisant le contenu de l'empilement.

**38.** Récepteur selon la revendication 37, adapté pour générer des informations fiables sur chaque sous-unité d'information décodée individuelle à partir de l'empilement.

**39.** Récepteur selon la revendication 33, adapté pour générer des informations fiables sur chaque sous-chemin du chemin décodé à partir des caractéristiques du processus de décodage séquentiel.

**40.** Récepteur selon les revendications 33 à 39, adapté pour effectuer la localisation de l'erreur au moyen d'une combinaison adéquate de deux ou de plusieurs des critères listés.

Quellencodierter Informationsblock

---

Schnittstelle Quellen- &
Kanalcodierung

Kanalcodierung
+
Übertragung
+
Kanaldecodierung

Fig. 1

Alte Schnittstelle
basierend auf
Bitfehlerwahrscheinlichkeit

---

falsch/richtig

Paket falsch oder richtig

---

Quellencodierter Informationsblock

---

Schnittstelle Quellen- &
Kanalcodierung

Kanalcodierung
+
Übertragung
+
Kanaldecodierung

Fig. 2

Neue Schnittstelle
basierend auf
Fehlerposition

---

$i$

Richtig bis zu Position $i$

Richtig decodierter Teil + eventueller Fehlerort

Fig. 3

Fig. 4

Abtastwerte im Frequenzbereich

Quantisierung

Zeitbereichs-/ Frequenzbereichs- Transformation

Psycho- akustisches Modell

Abtastwerte im Zeitbereich

Fig. 5

Optionale Quellen- codierung

Abtastwerte im Frequenzbereich

Quantisierung

Zeitbereichs-/ Frequenzbereichs- Transformation

Psycho- akustisches Modell

Abtastwerte im Zeitbereich